# EUROPEAN PATENT APPLICATION

(11) **EP 4 750 297 A1**
(43) Date of publication of application: **27.05.2026**
(21) Application number: 24844755.9
(22) Date of filing: 22.07.2024
(51) Int. Cl.: H10K 85/50, H10K 30/88, H10K 30/40

(54) **PEROVSKITE CRYSTAL, PRECURSOR SOLUTION, PEROVSKITE LAYER, PEROVSKITE CELL, PREPARATION METHOD, PHOTOVOLTAIC MODULE AND ELECTRICAL APPARATUS**

(30) Priority: 24.07.2023 CN 202310908816
(71) Applicant: Contemporary Amperex Technology Co., Limited, Ningde, Fujian 352100 (CN)
(72) Inventor: ZHOU, Chenhong, Ningde, Fujian 352100 (CN); GUO, Yongsheng, Ningde, Fujian 352100 (CN); CHEN, Guodong, Ningde, Fujian 352100 (CN); SU, Shuojian, Ningde, Fujian 352100 (CN); XU, Bo, Ningde, Fujian 352100 (CN); OUYANG, Chuying, Ningde, Fujian 352100 (CN)
(74) Representative: Ziebig Hengelhaupt Intellectual Property Attorneys Patentanwaltskanzlei PartGmbB
(86) International application number: PCT/CN2024/106703
(87) International publication number: WO 2025/021064

(57) **Abstract**

Provided are perovskite crystal, a precursor solution, a perovskite layer, a perovskite cell, a preparation method, a photovoltaic module, and an electrical apparatus. The perovskite crystal comprises one or more perovskite grains, the perovskite grain comprises a core portion and a passivation layer located on at least part of a surface of the core portion, the core portion comprises a first perovskite component, and the passivation layer comprises a second perovskite component. The perovskite cell has high stability and high photoelectric conversion efficiency.

## Description

### CROSS-REFERENCE TO RELATED APPLICATIONS

The present application claims priority to Chinese patent application No. 202310908816.3 filed on July 24, 2023 and entitled "PEROVSKITE CRYSTAL, PRECURSOR SOLUTION, PEROVSKITE LAYER, PEROVSKITE CELL, PREPARATION METHOD, PHOTOVOLTAIC MODULE AND ELECTRICAL APPARATUS," the entire content of which is incorporated herein by reference.

### TECHNICAL FIELD

The present application relates to perovskite crystal, a precursor solution, a perovskite layer, a perovskite cell, a preparation method, a photovoltaic module, and an electrical apparatus.

### BACKGROUND

With the development of modern industry, the problems of global energy shortage and environmental pollution have become increasingly prominent, and perovskite cells have attracted more and more attention as an ideal renewable energy source. Perovskite cells have potential advantages such as high efficiency and low cost, and are expected to show outstanding competitiveness in the next generation of solar cells. As one of important components of a perovskite cell, a perovskite crystal and a perovskite layer may affect the performance of the perovskite cell. However, a perovskite layer prepared so far typically has a high density of defect states inside and on the surface, and defect-assisted non-radiative recombination and impurity scattering may affect a carrier dynamics process. Therefore, improving a bulk quality and an interface quality of a perovskite layer and enhancing carrier transporting are of great significance to improving the performance of a cell device. The above statements are intended solely to offer background information relevant to the present application and do not necessarily constitute the prior art.

### SUMMARY OF THE INVENTION

The present application provides a perovskite crystal, a precursor solution, a perovskite layer, a perovskite cell, a preparation method, a photovoltaic module, and an electrical apparatus, wherein the perovskite cell has high stability and high photoelectric conversion efficiency.

A first aspect of the present application provides a perovskite crystal. The perovskite crystal includes one or more perovskite grains, and the perovskite grain includes a core portion and a passivation layer located on at least part of a surface of the core portion.

The core portion includes a first perovskite component, and the passivation layer includes a second perovskite component. The first perovskite component includes one or more of ABX₃ and A₂CDX₆, and the second perovskite component includes one or more of APbX₃. In ABX₃, A₂CDX₆, and APbX₃, A respectively and independently represents a monovalent inorganic cation, organic cation, or organic-inorganic mixed cation, and B represents a divalent inorganic cation, organic cation, or organic-inorganic mixed cation. In ABX₃, A₂CDX₆, and APbX₃, X respectively and independently represents a monovalent inorganic anion, organic anion, or organic-inorganic mixed anion, C represents a monovalent inorganic cation, organic cation, or organic-inorganic mixed cation, and D represents a trivalent inorganic cation, organic cation, or organic-inorganic mixed cation.

The perovskite crystal provided by this example of the present application includes one or more perovskite grains, and the perovskite grain includes the core portion and the passivation layer located on at least part of the surface of the core portion. The passivation layer includes the second perovskite component, and the second perovskite component includes a lead-based perovskite material APbX₃. This not only makes the perovskite crystal have high structural stability, but also makes the perovskite crystal have higher carrier transport capability. In addition, this helps to energy level matching between the perovskite layer and a charge transport layer, thereby helping to improve photoelectric conversion efficiency of a cell device.

In any example, the passivation layer and the core portion are integrally formed. This further improves stability and oxidation resistance of the perovskite crystal, and promotes carrier transporting, so that a cell device using the perovskite crystal has high stability and high photoelectric conversion efficiency.

In any example, the perovskite crystal further includes a third component. The third component is located on a surface and/or a grain boundary of the perovskite crystal. The third component includes an alkyl group substituted with at least one of a sulfonic acid group, a phosphoric acid group, a carboxylic acid group, a boronic acid group, a cyano group, an amino group, a quaternary ammonium salt, and a mercapto group. The molecular size of the third component is greater than a first threshold, and the first threshold represents the maximum ionic radius of the cations of the first perovskite component and the second perovskite component.

In any example, the third component includes one or more of dimethylphosphonic acid, 2,2-dimethylethyleneboronic acid, n-butylamine, glutaronitrile, 4-chlorobenzyl mercaptan, hydrocinnamic acid, and ethylsulfonic acid.

In any example, the ratio of the thickness of the passivation layer to a grain size of the perovskite grain is greater than 0 and less than or equal to 0.33:1. This makes a perovskite cell have both high stability and high photoelectric conversion efficiency.

In any example, the thickness of the passivation layer is 1-100 nm. This makes a perovskite cell have both high stability and high photoelectric conversion efficiency.

In any example, the grain size of the perovskite grain is 300-1,000 nm.

In any example, the passivation layer is located on 80-100% of the surface of the core portion. This helps a perovskite cell have high stability.

In any example, B includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺.

In any example, A in ABX₃, A₂CDX₆, and APbX₃ respectively and independently includes one or more of CH₃NH₃⁺, CH₃CH₂NH₃⁺, CH(NH₂)₂⁺, Li⁺, Na⁺, K⁺, Rb⁺, and Cs⁺.

In any example, X in ABX₃, A₂CDX₆, and APbX₃ respectively and independently represents a halogen ion.

In any example, C represents a monovalent metal cation.

In any example, D represents a trivalent metal cation.

A second aspect of the present application provides a precursor solution for preparing the perovskite crystal according to the first aspect. The precursor solution is obtained by mixing a first precursor solution and a second precursor solution.

The first precursor solution includes a first solvent and an A-site precursor compound AX and a B-site precursor compound BX₂ dissolved in the first solvent, or includes a first solvent and an A-site precursor compound AX, a C-site precursor compound CX, and a D-site precursor compound DX₃ dissolved in the first solvent.

The second precursor solution includes a second solvent and an A-site precursor compound AX, PbX₂, and a third component dissolved in the second solvent. The third component includes an alkyl group substituted with at least one of a sulfonic acid group, a phosphoric acid group, a carboxylic acid group, a boronic acid group, a cyano group, an amino group, a quaternary ammonium salt, and a mercapto group. The molecular size of the third component is greater than a first threshold, and the first threshold represents the maximum ionic radius of cations of the precursor compounds in the first precursor solution and the second precursor solution.

The second precursor solution includes the third component, and a molecular structure of the third component contains at least one functional group of the sulfonic acid group, the phosphoric acid group, the carboxylic acid group, the boronic acid group, the cyano group, the amino group, the quaternary ammonium salt, and the mercapto group. Therefore, the third component in the second precursor solution may complex Pb²⁺. Also, the molecular size of the third component is greater than the maximum ionic radius of the cations of the precursor compounds in the first precursor solution and the second precursor solution. When a perovskite crystal is prepared by using the mixed precursor solution, the third component cannot be located at a cation position of the perovskite crystal due to a large molecular size of the third component, and thus the third component may exist as an impurity. During a crystallization process, the third component may be squeezed to the grain boundary and the surfaces of the perovskite crystal. Moreover, the third component contains the group that can coordinate or complex with Pb²⁺. Therefore, during a grain growth process, the third component may drive Pb²⁺ to separate and reach the grain boundary and the surface of the perovskite crystal, to form a core-shell structured perovskite grain. In addition, the passivation layer of the integrally formed perovskite grain may simultaneously passivate grain boundary defects and surface defects.

The first precursor solution and the second precursor solution are prepared separately, and the second precursor solution includes the third component, while the first precursor solution does not include the third component. This makes the third component complex with Pb²⁺ in the second precursor solution and reduces complexation of the third component with an optional metal cation in the first precursor solution, thereby integrally forming the core-shell structured perovskite grain during the crystallization process.

In any example, the third component includes one or more of dimethylphosphonic acid, 2,2-dimethylethyleneboronic acid, n-butylamine, glutaronitrile, 4-chlorobenzyl mercaptan, hydrocinnamic acid, and ethylsulfonic acid.

In any example, the molar ratio of the third component to PbX₂ is 0.005:1 to 0.1:1. By adjusting the molar ratio of the third component to PbX₂ in the above range, the crystallized perovskite grain may have a complete passivation layer, for example, the passivation layer being located on 80-100% of the surface of the core portion, thereby helping to improve stability of a perovskite cell and also improve photoelectric conversion efficiency of a perovskite cell.

In any example, the first solvent includes dimethylformamide and dimethyl sulfoxide.

In any example, the second solvent includes dimethylformamide and dimethyl sulfoxide.

A third aspect of the present application provides a perovskite layer, including the perovskite crystal according to the first aspect of the present application.

A fourth aspect of the present application provides a method for preparing a perovskite layer, including the following steps: providing a substrate; providing a precursor solution for forming a perovskite layer; coating the precursor solution for forming a perovskite layer on the substrate to form a thin film; and removing the solvent from the thin film to form a perovskite layer.

The precursor solution for forming a perovskite layer is obtained by mixing a first precursor solution and a second precursor solution. The first precursor solution includes a first solvent and an A-site precursor compound AX and a B-site precursor compound BX₂ dissolved in the first solvent, or includes a first solvent and an A-site precursor compound AX, a C-site precursor compound CX, and a D-site precursor compound DX₃ dissolved in the first solvent. The second precursor solution includes a second solvent and an A-site precursor compound AX, PbX₂, and a third component dissolved in the second solvent. The third component includes an alkyl group substituted with at least one of a sulfonic acid group, a phosphoric acid group, a carboxylic acid group, a boric acid group, a cyano group, an amino group, a quaternary ammonium salt, and a mercapto group. The molecular size of the third component is greater than a first threshold, and the first threshold represents the maximum ionic radius of cations of the precursor compounds in the first precursor solution and the second precursor solution.

The perovskite layer includes a perovskite crystal, and the perovskite crystal includes one or more perovskite grains. The perovskite grain includes a core portion and a passivation layer located on at least part of a surface of the core portion. The core portion includes a first perovskite component, and the passivation layer includes a second perovskite component. The first perovskite component includes one or more of ABX₃ and A₂CDX₆, and the second perovskite component includes one or more of APbX₃. In ABX₃, A₂CDX₆, and APbX₃, A respectively and independently represents a monovalent inorganic cation, organic cation, or organic-inorganic mixed cation, and B represents a divalent inorganic cation, organic cation, or organic-inorganic mixed cation. In ABX₃, A₂CDX₆, and APbX₃, X respectively and independently represents a monovalent inorganic anion, organic anion, or organic-inorganic mixed anion, C represents a monovalent inorganic cation, organic cation, or organic-inorganic mixed cation, and D represents a trivalent inorganic cation, organic cation, or organic-inorganic mixed cation.

The perovskite layer prepared by the method provided in this example of the present application makes a perovskite cell have high stability and high photoelectric conversion efficiency.

In any example, the third component includes one or more of dimethylphosphonic acid, 2,2-dimethylethyleneboronic acid, n-butylamine, glutaronitrile, 4-chlorobenzyl mercaptan, hydrocinnamic acid, and ethylsulfonic acid.

In any example, the molar ratio of the third component to PbX₂ is 0.005:1 to 0.1:1. By adjusting the molar ratio of the third component to PbX₂ in the above range, the crystallized perovskite grain may have a complete passivation layer, for example, the passivation layer being located on 80-100% of the surface of the core portion, thereby helping to improve stability of a perovskite cell and also improve photoelectric conversion efficiency of a perovskite cell.

In any example, the first solvent includes dimethylformamide and dimethyl sulfoxide.

In any example, the second solvent includes dimethylformamide and dimethyl sulfoxide.

In any example, the step of removing the solvent from the thin film to form the perovskite layer includes the following step: transferring the substrate with the thin film formed to a hot stage to perform annealing treatment to form the perovskite layer.

A fifth aspect of the present application provides a perovskite cell, including: a first electrode, a second electrode, a perovskite layer, a first charge transport layer, and a second charge transport layer. The first electrode is close to a light incident side. The perovskite layer is located between the first electrode and the second electrode. The first charge transport layer is located between the first electrode and the perovskite layer. The second charge transport layer is located between the second electrode and the perovskite layer. The perovskite layer includes the perovskite layer according to the third aspect of the present application, or a perovskite layer prepared by the method according to the fourth aspect of the present application.

A sixth aspect of the present application provides a method for preparing a perovskite cell, including the following steps: providing a first electrode; forming a first charge transport layer on the first electrode; providing a precursor solution for forming a perovskite layer; coating the precursor solution for forming a perovskite layer on the first charge transport layer to form a thin film; removing the solvent from the thin film to form a perovskite layer; forming a second charge transport layer on the perovskite layer; and forming a second electrode on the second charge transport layer.

The precursor solution for forming a perovskite layer is obtained by mixing a first precursor solution and a second precursor solution. The first precursor solution includes a first solvent and an A-site precursor compound AX and a B-site precursor compound BX₂ dissolved in the first solvent, or includes a first solvent and an A-site precursor compound AX, a C-site precursor compound CX, and a D-site precursor compound DX₃ dissolved in the first solvent. The second precursor solution includes a second solvent and an A-site precursor compound AX, PbX₂, and a third component dissolved in the second solvent. The third component includes an alkyl group substituted with at least one of a sulfonic acid group, a phosphoric acid group, a carboxylic acid group, a boric acid group, a cyano group, an amino group, a quaternary ammonium salt, and a mercapto group. The molecular size of the third component is greater than a first threshold, and the first threshold represents the maximum ionic radius of cations of the precursor compounds in the first precursor solution and the second precursor solution.

The perovskite layer includes a perovskite crystal, and the perovskite crystal includes one or more perovskite grains. The perovskite grain includes a core portion and a passivation layer located on at least part of a surface of the core portion. The core portion includes a first perovskite component, and the passivation layer includes a second perovskite component. The first perovskite component includes one or more of ABX₃ and A₂CDX₆, and the second perovskite component includes one or more of APbX₃. In ABX₃, A₂CDX₆, and APbX₃, A respectively and independently represents a monovalent inorganic cation, organic cation, or organic-inorganic mixed cation, and B represents a divalent inorganic cation, organic cation, or organic-inorganic mixed cation. In ABX₃, A₂CDX₆, and APbX₃, X respectively and independently represents a monovalent inorganic anion, organic anion, or organic-inorganic mixed anion, C represents a monovalent inorganic cation, organic cation, or organic-inorganic mixed cation, and D represents a trivalent inorganic cation, organic cation, or organic-inorganic mixed cation.

The perovskite cell prepared by the method provided by this example of the present application may have high stability and high photoelectric conversion efficiency.

In any example, the third component includes one or more of dimethylphosphonic acid, 2,2-dimethylethyleneboronic acid, n-butylamine, glutaronitrile, 4-chlorobenzyl mercaptan, hydrocinnamic acid, and ethylsulfonic acid.

In any example, the molar ratio of the third component to PbX₂ is 0.005:1 to 0.1:1. By adjusting the molar ratio of the third component to PbX₂ in the above range, the crystallized perovskite grain may have a complete passivation layer, for example, the passivation layer being located on 80-100% of the surface of the core portion, thereby helping to improve stability of a perovskite cell and also improve photoelectric conversion efficiency of a perovskite cell.

In any example, the first solvent includes dimethylformamide and dimethyl sulfoxide.

In any example, the second solvent includes dimethylformamide and dimethyl sulfoxide.

In any example, the step of removing the solvent from the thin film to form the perovskite layer includes the following step: transferring the first electrode with the thin film formed to a hot stage to perform annealing treatment to form the perovskite layer.

A seventh aspect of the present application provides another perovskite layer, including a middle portion and a passivation portion located on at least part of a surface of the middle portion. The middle portion includes a perovskite crystal. The passivation portion includes a first passivation portion located on an upper and/or lower surface of the middle portion along a thickness direction, and a second passivation portion located on outer peripheral surfaces of the middle portion. The first passivation portion and the second passivation portion respectively and independently include a passivation material. The passivation material includes one or more of a lead-based perovskite material, lead sulfide, silicon carbide, an oxide, a polymer, and a small organic molecule.

By providing the passivation material on the upper surface and/or lower surface of the middle portion along the thickness direction and on the outer peripheral surfaces of the middle portion, a defect state density of the perovskite layer may be reduced, nonradiative recombination and impurity scattering can be reduced, and stability of a cell device can be improved. The lead-based perovskite material, lead sulfide, silicon carbide, oxide, polymer, and small organic molecule have passivation capabilities and may also transport carriers, thereby making a cell device have high photoelectric conversion efficiency.

In any example, the ratio of the thickness of the first passivation portion to the thickness of the middle portion is 1:5 to 1:20. This makes a perovskite cell have both high stability and high photoelectric conversion efficiency.

In any example, the ratio of the thicknes of the second passivation portion to the thickness of the middle portion is 1:5 to 1:20. This makes a perovskite cell have both high stability and high photoelectric conversion efficiency.

In any example, the thickness of the middle portion is 400-1,000 nm.

In any example, the oxides include one or more of lead oxide, silicon oxide, aluminum oxide, and tin oxide. This not only improves stability of a cell device, but also promotes carrier transporting and improves photoelectric conversion efficiency of a cell device.

In any example, the polymer includes one or more of homopolymers and copolymers of at least one monomer from vinyl chloride, thiophene and a derivative thereof, carbazole and a derivative thereof, and styrene sulfonic acid. This makes a perovskite cell have both high stability and high photoelectric conversion efficiency.

In any example, the small organic molecule includes a compound containing at least one of a halogen atom and a heteroatom, and the heteroatom includes one or more of N, S, and O. This makes a perovskite cell have both high stability and high photoelectric conversion efficiency.

In any example, the perovskite crystal includes the perovskite crystal according to the first aspect of the present application.

An eighth aspect of the present application provides another perovskite cell, including: a first electrode, a second electrode, a perovskite layer, a first charge transport layer, and a second charge transport layer. The first electrode is close to a light incident side. The perovskite layer is located between the first electrode and the second electrode. The first charge transport layer is located between the first electrode and the perovskite layer. The second charge transport layer is located between the second electrode and the perovskite layer. The perovskite layer includes the perovskite layer according to the seventh aspect of the present application.

In any example, the first charge transport layer is a hole transport layer, the second charge transport layer is an electron transport layer, and a LUMO energy level of the first passivation portion is lower than a CBM energy level of the middle portion. This helps to promote carrier transporting, and also helps to improve photoelectric conversion efficiency of a cell device.

In any example, the first charge transport layer is an electron transport layer, the second charge transport layer is a hole transport layer, and a HOMO energy level of the first passivation portion is greater than a VBM energy level of the middle portion. This helps to promote carrier transporting, and also helps to improve photoelectric conversion efficiency of a cell device.

In any example, the first charge transport layer is a hole transport layer, and the second charge transport layer is an electron transport layer. The passivation portion includes a first passivation portion located on a surface of the middle portion away from the first charge transport layer, and a second passivation portion located on outer peripheral surfaces of the middle portion, and a LUMO energy level of the first passivation portion is lower than a CBM energy level of the middle portion. This helps to promote carrier transporting, and also helps to improve photoelectric conversion efficiency of a cell device.

In any example, the first charge transport layer is an electron transport layer, and the second charge transport layer is a hole transport layer. The passivation portion includes a first passivation portion located on a surface of the middle portion away from the first charge transport layer, and a second passivation portion located on outer peripheral surfaces of the middle portion, and a HOMO energy level of the first passivation portion is greater than a VBM energy level of the middle portion. This helps to promote carrier transporting, and also helps to improve photoelectric conversion efficiency of a cell device.

A ninth aspect of the present application provides a method for preparing the perovskite cell according to the eighth aspect of the present application, the method including the following steps: providing a first electrode; forming a first charge transport layer on the first electrode; forming a perovskite layer on the first charge transport layer; forming a second charge transport layer on the perovskite layer; and forming a second electrode on the second charge transport layer.

In any example, a method for forming the perovskite layer on the first charge transport layer includes a solution method, a hydrothermal method, and a vapor deposition method.

In any example, the step of forming the perovskite layer on the first charge transport layer includes the following steps: providing a passivation material and a precursor solution for forming the middle portion; and mixing the passivation material with the precursor solution for forming the middle portion and applying the mixture to the first charge transport layer to form the perovskite layer. The molar ratio of the passivation material to the precursor for forming the middle portion is 0.01:1 to 0.25:1. By adjusting the molar ratio of the passivation material to the precursor for forming the middle portion in the above range, the first passivation portion may be formed on the upper surface and/or lower surface of the middle portion along the thickness direction, and the second passivation portion can be formed on the outer peripheral surfaces of the middle portion simultaneously.

In any example, the step of forming the perovskite layer on the first charge transport layer includes the following steps: providing a precursor solution for forming a middle portion, wherein the precursor solution for forming a middle portion is obtained by mixing a first precursor solution and a second precursor solution; the first precursor solution includes a first solvent and an A-site precursor compound AX and a B-site precursor compound BX₂ dissolved in the first solvent, or includes a first solvent and an A-site precursor compound AX, a C-site precursor compound CX, and a D-site precursor compound DX₃ dissolved in the first solvent; the second precursor solution includes a second solvent and an A-site precursor compound AX, PbX₂, and a third component dissolved in the second solvent, the third component includes an alkyl group substituted with at least one of a sulfonic acid group, a phosphoric acid group, a carboxylic acid group, a boric acid group, a cyano group, an amino group, a quaternary ammonium salt, and a mercapto group, the molecular size of the third component is greater than a first threshold, and the first threshold represents the maximum ionic radius of cations of the precursor compounds in the first precursor solution and the second precursor solution; coating the precursor solution for forming a middle portion on the first charge transport layer to form a thin film; removing the solvent from the thin film to form a middle portion; and applying a passivation material to an upper surface and outer peripheral surfaces of the middle portion to complete preparation of the perovskite layer. Thus, the perovskite crystal formed in the middle portion may include the perovskite crystal according to the first aspect of the present application.

In any example, before the precursor solution for forming the middle portion is coated on the first charge transport layer to form the thin film, the method further includes a step of: applying a passivation material to the first charge transport layer.

A tenth aspect of the present application provides a photovoltaic module, including the perovskite cell according to the fifth aspect of the present application, or the perovskite cell prepared by the method according to the sixth aspect of the present application, or the perovskite cell according to the eighth aspect of the present application, or the perovskite cell prepared by the method according to the ninth aspect of the present application.

An eleventh aspect of the present application provides an electrical apparatus, including one or more of the perovskite cell according to the fifth aspect of the present application, the perovskite cell prepared by the method according to the sixth aspect of the present application, the perovskite cell according to the eighth aspect of the present application, the perovskite cell prepared by the method according to the ninth aspect of the present application, and the photovoltaic module according to the tenth aspect of the present application, wherein the perovskite cell and the photovoltaic module are used to supply power to the electrical apparatus.

The electrical apparatus of the present application includes the perovskite cell provided by the present application, and therefore has at least the same advantages as the perovskite cell.

### DESCRIPTION OF DRAWINGS

To more clearly illustrate the technical solutions of examples of the present application, the following provides a brief description of the accompanying drawings used in the examples of the present application. It is apparent that the accompanying drawings described below are only some embodiments of the present application. For those of ordinary skill in the art, other accompanying drawings can also be obtained based on the drawings without any creative effort.
FIG. 1 is a schematic structural diagram of a perovskite grain provided in some examples of the present application.
FIG. 2 is a schematic structural diagram of a perovskite cell provided in some examples of the present application.
FIG. 3 is a schematic structural diagram of a perovskite cell provided in some other examples of the present application.
FIG. 4 is a schematic structural diagram of a perovskite cell provided in still some other examples of the present application.

The drawings may not be drawn in accordance with the actual scale. The reference numerals in the drawings are as follows: 1. First electrode; 2. First charge transport layer; 3. Perovskite layer; 4. Second charge transport layer; 5. Second electrode; 31. Perovskite grain; 311. Core portion; 312. Passivation layer; 32. Middle portion; 33. Passivation portion; 331. First passivation portion; and 332. Second passivation portion.

### DETAILED DESCRIPTION

Embodiments of a perovskite crystal, a precursor solution, a perovskite layer, a perovskite cell, a preparation method, a photovoltaic module, and an electrical apparatus are disclosed specifically below with reference to the detailed description of drawings as appropriate. However, there may be cases where unnecessary detailed descriptions are omitted. For example, there are cases where detailed descriptions of well-known items and repeated descriptions of actually identical structures are omitted. This is to avoid unnecessary redundancy in the following descriptions and to facilitate understanding by those skilled in the art. In addition, the accompanying drawings and subsequent descriptions are provided for those skilled in the art to fully understand the present application, and are not intended to limit the subject matter recited in the claims.

The "ranges" disclosed in the present application are defined in the form of lower and upper limits. A given range is defined by selecting a lower limit and an upper limit, and the selected lower and upper limits define the boundaries of the particular range. The range defined in this way may include or may not include end values, and may be arbitrarily combined, that is, any lower limit may be combined with any upper limit to form a range. For example, if the ranges 60-120 and 80-110 are listed for specific parameters, it is understood that the ranges 60-110 and 80-120 are also expected. In addition, if the listed minimum range values are 1 and 2 and if the listed maximum range values are 3, 4, and 5, the following ranges can all be expected: 1-3, 1-4, 1-5, 2-3, 2-4, and 2-5. In the present application, unless otherwise specified, the numerical range "a-b" represents an abbreviated representation of any combination of real numbers between a and b, wherein a and b are both real numbers. For example, the numerical range "0-5" indicates that all real numbers between "0-5" have been listed herein, and "0-5" is only a shortened representation of these numerical combinations. In addition, when a parameter is expressed as an integer greater than or equal to 2, it is equivalent to disclosing that the parameter is, for example, an integer of 2, 3, 4, 5, 6, 7, 8, 9, 10, 11, 12, and the like.

Unless otherwise specifically stated, all embodiments and optional embodiments of the present application may be combined with each other to form new technical solutions, and such technical solutions should be considered as being included in the disclosure of the present application.

Unless otherwise specifically stated, all technical features and optional technical features of the present application may be combined with each other to form new technical solutions, and such technical solutions should be considered as being included in the disclosure of the present application.

Unless otherwise specifically stated, all steps in the present application may be performed sequentially or randomly, and are preferably performed sequentially. For example, the method including steps (a) and (b), indicates that the method may include steps (a) and (b) performed sequentially, or may include steps (b) and (a) performed sequentially. For example, the reference to the method further including step (c), indicates that step (c) may be added to the method in any order, for example, the method may include steps (a), (b) and (c), or may include steps (a), (c) and (b), or may include steps (c), (a) and (b), and so on.

Unless otherwise particularly specified, in the present application, the terms "first", "second" and the like are used to distinguish different objects rather than describe a particular order or primary-secondary relationship.

Unless otherwise specified, the terms used in the present application have well-known meanings as commonly understood by those skilled in the art.

Unless otherwise stated, numerical values of parameters mentioned in the present application may be measured using various testing methods commonly used in the art. For example, the numerical values may be measured according to testing methods given in the present application. Unless otherwise specified, the test temperature for all parameters is 25°C.

The term "small organic molecule" is used with its ordinary meaning in the art. Typically, a small organic molecule contains a carbon atom. And those skilled in the art may understand that the term "small organic molecule" typically does not include a compound that is primarily in an ionic form, for example, a carbide.

### [Perovskite crystal]

In a first aspect, an example of the present application provides a perovskite crystal that can be used in a perovskite cell.

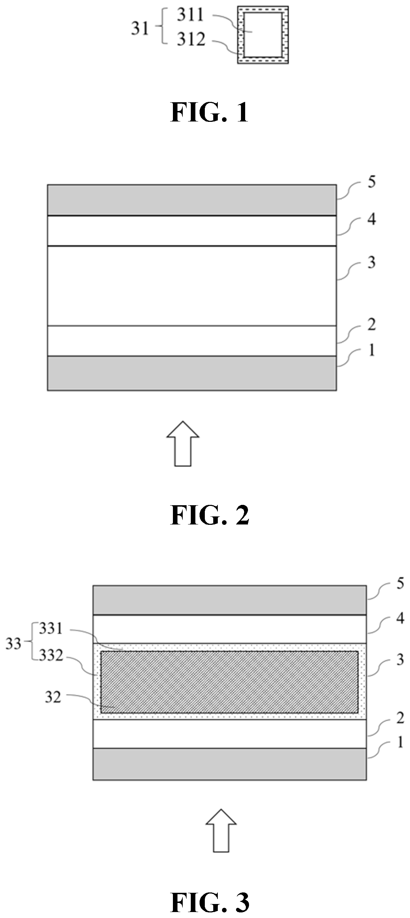

FIG. 1 is a schematic structural diagram of a perovskite grain provided in some examples of the present application.

As shown in FIG. 1, the perovskite crystal includes one or more perovskite grains 31, and the perovskite grain 31 includes a core portion 311 and a passivation layer 312 located on at least part of a surface of the core portion 311.

The core portion 311 includes a first perovskite component, and the passivation layer 312 includes a second perovskite component.

The first perovskite component includes one or more of ABX₃ and A₂CDX₆, and the second perovskite component includes one or more of APbX₃.

In ABX₃, A₂CDX₆, and APbX₃, A respectively and independently represents a monovalent inorganic cation, organic cation, or organic-inorganic mixed cation, and B represents a divalent inorganic cation, organic cation, or organic-inorganic mixed cation. In ABX₃, A₂CDX₆, and APbX₃, X respectively and independently represents a monovalent inorganic anion, organic anion, or organic-inorganic mixed anion, C represents a monovalent inorganic cation, organic cation, or organic-inorganic mixed cation, and D represents a trivalent inorganic cation, organic cation, or organic-inorganic mixed cation.

The perovskite crystal includes one or more perovskite grains, so that the perovskite crystal may be single-crystal or polycrystal.

The working principle of a perovskite cell is typically as follows: under an illumination condition, a perovskite layer absorbs photon energy and generates electron-hole pairs in a valence band of the perovskite layer, and electrons are excited to a conduction band and leave holes in the valence band. The energy level of a conduction band of the perovskite layer is typically higher than that of a conduction band of an electron transport layer, so that electrons may be transported from the conduction band position of the perovskite layer to the conduction band position of the electron transport layer, and then transported to a conductive electrode. The energy level of the valence band of the perovskite layer is typically lower than that of a valence band of the hole transport layer, so that holes may be transported to the conductive electrode via the hole transport layer. Therefore, when an external circuit is connected, a complete loop is formed and photocurrent is generated.

A perovskite crystal, such as a tin-lead mixed perovskite crystal, has problems such as easy oxidation, non-uniformity, and rapid nucleation and crystallization, so that a perovskite layer typically has a high density of defect states inside and on the surface, and defect-assisted non-radiative recombination and impurity scattering may affect a carrier dynamics process.

A passivation layer having a passivation effect provided on the surface of a perovskite grain may improve stability of a perovskite crystal, reduce the density of defect states of a perovskite layer, and improve oxidation resistance of a perovskite layer, thereby improving stability of a cell device. However, a current passivation layer is typically formed by direct coating or deposition on a surface of a prepared perovskite crystal, and thus an interface may be formed between the perovskite crystal and the passivation layer on the surface thereof. The presence of the interface may affect stability of the perovskite crystal and also affect carrier transporting. Also, defects at the grain boundary of a perovskite grain cannot be passivated, and thus stability of the perovskite crystal may be affected. In addition, a passivation layer on a surface of a current perovskite crystal typically uses some inactive molecules, which may affect carrier transporting and thus affect photoelectric conversion efficiency of a cell device.

The perovskite crystal provided by this example of the present application includes one or more perovskite grains, and the perovskite grain includes the core portion and the passivation layer located on at least part of the surface of the core portion. The passivation layer includes the second perovskite component, and the second perovskite component includes a lead-based perovskite material APbX₃. This not only makes the perovskite crystal have high structural stability, but also makes the perovskite crystal have higher carrier transport capability. In addition, this helps to energy level matching between the perovskite layer and a charge transport layer, thereby helping to improve photoelectric conversion efficiency of a cell device.

The passivation layer 312 and the core portion 311 are integrally formed. The passivation layer and the core portion being integrally formed means that no interface exists between the passivation layer and the core portion, and the material of the passivation layer is different from that of the core portion.

The core portion and the passivation layer of the perovskite grain provided in this example of the present application are integrally formed, thereby further improving stability and oxidation resistance of the perovskite crystal, and promoting carrier transporting, so that a cell device using the perovskite crystal has high stability and high photoelectric conversion efficiency.

Therefore, a perovskite cell using the perovskite crystal provided in this example of the present application may have high stability and high photoelectric conversion efficiency.

In some examples, B in ABX₃ may include one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺.

In some examples, B in ABX₃ may include one or both of Pb²⁺ and Sn²⁺.

In some examples, B in ABX₃ may include Sn²⁺, or B in ABX₃ may include both b²⁺ and Sn²⁺.

Lead-tin perovskite cells are a new high-efficiency solar cell technology. Compared with other perovskite crystals, a lead-tin mixed perovskite crystal has a narrower band gap and lower toxicity, and is an ideal bottom cell material for a stacked cell. However, a lead-tin perovskite cell has a serious oxidation problem which is mainly due to the presence of Sn²⁺ on the surface of a perovskite crystal and a passivation layer. Sn²⁺ has high reducibility in an oxidation-reduction reaction and is easily oxidized into Sn⁴⁺. However, an electronic structure of the Sn⁴⁺ is unstable and is likely to form electron-hole pairs, thereby increasing the difficulty of carrier transporting inside the lead-tin perovskite cell and reducing photoelectric conversion efficiency and stability of the lead-tin perovskite cell.

The perovskite crystal provided by this example of the present application includes one or more perovskite grains, and the perovskite grain includes the core portion and the passivation layer located on at least part of the surface of the core portion. The passivation layer includes the second perovskite component, and the second perovskite component includes the lead-based perovskite material. Therefore, stable Pb²⁺ exist on the surfaces of the perovskite grain, the perovskite crystal, and the perovskite layer, and thus Sn²⁺ in the perovskite layer may be reduced or even prevented from being oxidized into Sn⁴⁺, thereby improving stability of a cell device and also making the cell device have high photoelectric conversion efficiency.

In some examples, B in ABX₃ may include Pb²⁺, and A in APbX₃ may represent a monovalent inorganic cation. Optionally, A in APbX₃ may include one or more of Li⁺, Na⁺, K⁺, Rb⁺, and Cs⁺. More optionally, A in APbX₃ may include Cs⁺.

When the first perovskite component also includes a lead-based perovskite material, an A site in the second perovskite component in the passivation layer uses a more stable monovalent inorganic cation, thereby helping to improve structural stability of the perovskite crystal and stability of a cell device.

In some examples, A in ABX₃, A₂CDX₆, and APbX₃ may respectively and independently include one or more of CH₃NH₃⁺ (MA⁺), CH₃CH₂NH₃⁺, CH(NH₂)₂⁺ (FA⁺), Li⁺, Na⁺, K⁺, Rb⁺, and Cs⁺. Optionally, A in ABX₃, A₂CDX₆, and APbX₃ may respectively and independently include one or more of CH₃NH₃⁺, CH₃CH₂NH₃⁺, CH(NH₂)₂⁺, and Cs⁺.

A in ABX₃, A₂CDX₆, and APbX₃ may be the same or different, which is not limited in this example of the present application.

In some examples, X in ABX₃, A₂CDX₆, and APbX₃ may respectively and independently represent a halogen ion. Optionally, X in ABX₃, A₂CDX₆, and APbX₃ may respectively and independently include one or more of F⁻, Cl⁻, Br⁻, and I⁻. More optionally, X in ABX₃, A₂CDX₆, and APbX₃ may respectively and independently include one or more of Cl⁻, Br⁻, and I⁻.

X in ABX₃, A₂CDX₆, and APbX₃ may be the same or different, which is not limited in this example of the present application.

In some examples, C in A₂CDX₆ may represent a monovalent metal cation. Optionally, C in A₂CDX₆ may include one or more of Li⁺, Na⁺, K⁺, Rb⁺, Cs⁺, and Ag⁺.

In some examples, D in A₂CDX₆ may represent a trivalent metal cation. Optionally, D in A₂CDX₆ may include one or more of In³⁺, Bi³⁺, and Sb³⁺.

In some examples, the perovskite crystal further includes a third component. The third component is located on a surface and/or a grain boundary of the perovskite crystal. The third component includes an alkyl group substituted with at least one of a sulfonic acid group, a phosphoric acid group, a carboxylic acid group, a boronic acid group, a cyano group, an amino group, a quaternary ammonium salt, and a mercapto group. The molecular size of the third component is greater than a first threshold, and the first threshold represents the maximum ionic radius of the cations of the first perovskite component and the second perovskite component.

Optionally, the third component may include one or more of dimethylphosphonic acid, 2,2-dimethylethyleneboronic acid, n-butylamine, glutaronitrile, 4-chlorobenzyl mercaptan, hydrocinnamic acid, and ethylsulfonic acid.

In some examples, the ratio of the thickness of the passivation layer of the perovskite grain to a grain size of the perovskite grain is greater than 0 and less than or equal to 0.33:1.

Optionally, the ratio of the thickness of the passivation layer of the perovskite grain to the grain size of the perovskite grain may be 0.002:1 to 0.23:1, 0.005:1 to 0.20:1, 0.01:1 to 0.17:1, and 0.02:1 to 0.14:1. This makes a perovskite cell have both high stability and high photoelectric conversion efficiency.

In some examples, the thickness of the passivation layer of the perovskite grain may be 1-100 nm. For example, the thickness of the passivation layer may be 1 nm, 3 nm, 5 nm, 10 nm, 15 nm, 20 nm, 28 nm, 44 nm, 56 nm, 65 nm, 71 nm, 80 nm, 94 nm, or 100 nm, or in a range consisting of any of the above values. Optionally, the thickness of the passivation layer of the perovskite grain may be in 10-94 nm, 12-71 nm, or 15-56 nm. This makes a perovskite cell have both high stability and high photoelectric conversion efficiency.

The grain size of the perovskite grain is not specifically limited. In some examples, the grain size of the perovskite grain may be 300-1,000 nm. For example, the grain size of the perovskite crystal may be 300 nm, 400 nm, 500 nm, 600 nm, 700 nm, 800 nm, 900 nm, or 1,000 nm, or in a range consisting of any of the above values.

The thickness of the passivation layer of the perovskite grain may be measured using a scanning electron microscope or a transmission electron microscope. During measurement, 10 areas may be randomly selected in the perovskite layer. For each area, 3 to 5 cross-sectional images of the perovskite layer may be obtained using a scanning electron microscope or a transmission electron microscope. The maximum thickness of the passivation layer in each cross-sectional image is recorded, and an average value is taken as the thickness of the passivation layer of the perovskite grain.

The grain size of the perovskite grain may be measured using a scanning electron microscope or a transmission electron microscope. During measurement, a top view of the perovskite layer may be obtained using a scanning electron microscope or a transmission electron microscope. 3 areas are randomly selected from the top view of the perovskite layer (ensuring that the number of perovskite grains in each area is greater than or equal to 80). The grain size of all perovskite grains in the three regions is obtained, and then, an average value is taken as the grain size of the perovskite grain. In the top view of the perovskite layer, the maximum length of all perovskite grains is taken as the grain size of the perovskite grains.

In some examples, the passivation layer may be located on 80-100% of the surface of the core portion. This helps a perovskite cell have high stability.

In some examples, the first perovskite component may include, but is not limited to, one or more of CH₃NH₃PbI₃ (MAPbI₃), CH(NH₂)₂PbI₃ (FAPbI₃), Cs_{0.05}(FA_{0.83}MA_{0.17})_{0.95}Pb(I_{0.83}Br_{0.17})₃, CsPbI₃, CsPbI₂Br, CsPbIBr₂, FAPb_{0.5}Sn_{0.5}I₃, MAPb_{0.5}Sn_{0.5}I₃, FASnI₃, MASnI₃, CsSnI₃, Cs_{0.2}FA_{0.8}Pb_{0.5}Sn_{0.5}I₃, MA_{0.2}FA_{0.8}Pb_{0.5}Sn_{0.5}I₃, MA_{0.5}FA_{0.5}Pb_{0.5}Sn_{0.5}I₃, Cs_{0.2}MA_{0.8}Pb_{0.5}Sn_{0.5}I₃, Cs₂NaInCl₆, Cs₂KBiCl₆, and Cs₂AgInCl₆.

In some examples, the second perovskite component may include, but is not limited to, one or more of CH₃NH₃PbI₃ (MAPbI₃), CH(NH₂)₂PbI₃ (FAPbI₃), Cs_{0.05}(FA_{0.83}MA_{0.17})_{0.95}Pb(I_{0.83}Br_{0.17})₃, CsPbCl₃, MAPbCl₃, FAPbCl₃, FAPbBr₃, MAPbBr₃, CsPbBr₃, CsPbBr₃, CsPbI₃, CsPbI₂Br, and CsPbIBr₂.

### [Precursor solution]

In a second aspect, an example of the present application further provides a precursor solution for preparing the perovskite crystal provided in the first aspect of the examples of the present application.

The precursor solution is obtained by mixing a first precursor solution and a second precursor solution.

The first precursor solution includes a first solvent and an A-site precursor compound AX and a B-site precursor compound BX₂ dissolved in the first solvent, or includes a first solvent and an A-site precursor compound AX, a C-site precursor compound CX, and a D-site precursor compound DX₃ dissolved in the first solvent.

The second precursor solution includes a second solvent and an A-site precursor compound AX,PbX₂, and a third component dissolved in the second solvent. The third component includes an alkyl group substituted with at least one of a sulfonic acid group, a phosphoric acid group, a carboxylic acid group, a boronic acid group, a cyano group, an amino group, a quaternary ammonium salt, and a mercapto group. The molecular size of the third component is greater than a first threshold, and the first threshold represents the maximum ionic radius of cations of the precursor compounds in the first precursor solution and the second precursor solution.

The second precursor solution includes the third component, and a molecular structure of the third component contains at least one functional group of the sulfonic acid group, the phosphoric acid group, the carboxylic acid group, the boronic acid group, the cyano group, the amino group, the quaternary ammonium salt, and the mercapto group. Therefore, the third component in the second precursor solution may complex Pb²⁺. Also, the molecular size of the third component is greater than the maximum ionic radius of the cations of the precursor compounds in the first precursor solution and the second precursor solution. When a perovskite crystal is prepared by using the mixed precursor solution, the third component cannot be located at a cation position of the perovskite crystal due to a large molecular size of the third component, and thus the third component may exist as an impurity. During a crystallization process, the third component may be squeezed to the grain boundary and the surfaces of the perovskite crystal. Moreover, the third component contains the group that can coordinate or complex with Pb²⁺. Therefore, during a grain growth process, the third component may drive Pb²⁺ to separate and reach the grain boundary and the surface of the perovskite crystal, to form a core-shell structured perovskite grain. In addition, the passivation layer of the integrally formed perovskite grain may simultaneously passivate grain boundary defects and surface defects.

The first precursor solution and the second precursor solution are prepared separately, and the second precursor solution includes the third component, while the first precursor solution does not include the third component. This makes the third component complex with Pb²⁺ in the second precursor solution and reduces complexation of the third component with an optional metal cation in the first precursor solution, thereby integrally forming the core-shell structured perovskite grain during the crystallization process.

In the above preparation method, the second precursor solution may form the second perovskite component in the passivation layer.

In the above preparation method, the first precursor solution may form the first perovskite component in the core portion. Or, the first precursor solution and the second precursor solution together form the first perovskite component in the core portion, whereby, in a crystallization process, a portion of the second precursor solution forms the second perovskite component in the passivation layer, and the other portion co-crystallizes with the first precursor solution to form the first perovskite component in the core portion.

A in the first precursor solution and A in the second precursor solution may be the same or different; X in the first precursor solution and X in the second precursor solution may be the same or different; X in the A-site precursor compound AX in the first precursor solution and X in the B-site precursor compound BX₂ may be the same or different; and X in the A-site precursor compound AX in the second precursor solution and X in PbX₂ may be the same or different. Those skilled in the art may make adjustments according to actual conditions to prepare the aforementioned perovskite crystal.

In some examples, the third component may include one or more of dimethylphosphonic acid, 2,2-dimethylethyleneboronic acid, n-butylamine, glutaronitrile, 4-chlorobenzyl mercaptan, hydrocinnamic acid, and ethylsulfonic acid.

In some examples, the molar ratio of the third component to PbX₂ may be 0.005:1 to 0.1:1, optionally 0.01:1 to 0.05:1.

By adjusting the molar ratio of the third component to PbX₂ in the above range, the crystallized perovskite grain may have a complete passivation layer, for example, the passivation layer being located on 80-100% of the surface of the core portion, thereby helping to improve stability of a perovskite cell and also improve photoelectric conversion efficiency of a perovskite cell. When the molar ratio of the third component to PbX₂ is small, the passivation layer of the crystallized perovskite grain maybe not complete enough, which is not conducive to modifying grain boundary defects and surface defects of the perovskite crystal, and thus reduces stability of a prepared cell device. When the molar ratio of the third component to PbX₂ is large, the excess third component may complex with metal cations in the first perovskite component, which is not conducive to formation of a core-shell structured perovskite grain, and further not conducive to improving the stability of the cell device. In addition, the excessive third component may accumulate (or stack) on the surface and the grain boundary of the perovskite crystal, and thus increases an interface resistance of the perovskite layer, affects carrier transporting, and further affects photoelectric conversion efficiency of the cell device.

In some examples, the first solvent may include, but is not limited to, dimethylformamide (DMF) and dimethyl sulfoxide (DMSO). Optionally, the volume ratio of the DMF to the DMSO may be 2:1 to 9:1.

In some examples, the second solvent may include, but is not limited to, DMF and DMSO. Optionally, the volume ratio of the DMF to the DMSO may be 2:1 to 9:1.

### [Perovskite layer]

In a third aspect, an example of the present application further provides a perovskite layer, including the perovskite crystal provided in the first aspect of the examples of the present application.

### [Method for preparing perovskite layer]

In a fourth aspect, an example of the present application further provides a method for preparing the perovskite layer provided in the third aspect of the examples of the present application.

The method includes the following steps: a substrate is provided; a precursor solution for forming a perovskite layer is provided; the precursor solution for forming a perovskite layer is coated on the substrate to form a thin film; and the solvent is removed from the thin film to form a perovskite layer.

The precursor solution for forming a perovskite layer is obtained by mixing a first precursor solution and a second precursor solution. The first precursor solution includes a first solvent and an A-site precursor compound AX and a B-site precursor compound BX₂ dissolved in the first solvent, or includes a first solvent and an A-site precursor compound AX, a C-site precursor compound CX, and a D-site precursor compound DX₃ dissolved in the first solvent. The second precursor solution includes a second solvent and an A-site precursor compound AX, PbX₂, and a third component dissolved in the second solvent. The third component includes an alkyl group substituted with at least one of a sulfonic acid group, a phosphoric acid group, a carboxylic acid group, a boronic acid group, a cyano group, an amino group, a quaternary ammonium salt, and a mercapto group. The molecular size of the third component is greater than a first threshold, and the first threshold represents the maximum ionic radius of cations of the precursor compounds in the first precursor solution and the second precursor solution.

The perovskite layer includes a perovskite crystal, and the perovskite crystal includes one or more perovskite grains. The perovskite grain includes a core portion and a passivation layer located on at least part of a surface of the core portion. The core portion includes a first perovskite component, and the passivation layer includes a second perovskite component. The first perovskite component includes one or more of ABX₃ and A₂CDX₆, and the second perovskite component includes one or more of APbX₃. In ABX₃, A₂CDX₆, and APbX₃, A respectively and independently represents a monovalent inorganic cation, organic cation, or organic-inorganic mixed cation, and B represents a divalent inorganic cation, organic cation, or organic-inorganic mixed cation. In ABX₃, A₂CDX₆, and APbX₃, X respectively and independently represents a monovalent inorganic anion, organic anion, or organic-inorganic mixed anion, C represents a monovalent inorganic cation, organic cation, or organic-inorganic mixed cation, and D represents a trivalent inorganic cation, organic cation, or organic-inorganic mixed cation.

In some examples, the perovskite crystal further includes a third component located on a surface and/or a grain boundary of the perovskite crystal.

The third component in the second precursor solution may complex Pb²⁺, and the molecular size of the third component is greater than the maximum ionic radius of the cations of the precursor compounds in the first precursor solution and the second precursor solution. When a perovskite layer is formed by using the mixed precursor solution, the third component cannot be located at a cation position of the perovskite crystal due to a large molecular size of the third component, and thus the third component may exist as an impurity. During a crystallization process, the third component may be squeezed to the grain boundary and the surfaces of the perovskite crystal. Moreover, the third component contains the group that can coordinate or complex with Pb²⁺. Therefore, during a grain growth process, the third component may drive Pb²⁺ to separate and reach the grain boundary and the surface of the perovskite crystal, to form a core-shell structured perovskite grain. In addition, the passivation layer of the integrally formed perovskite grain may simultaneously passivate grain boundary defects and surface defects.

The first precursor solution and the second precursor solution are prepared separately, and the second precursor solution includes the third component, while the first precursor solution does not include the third component. This makes the third component complex with Pb²⁺ in the second precursor solution and reduces complexation of the third component with an optional metal cation in the first precursor solution, thereby integrally forming the core-shell structured perovskite grain during the crystallization process.

Therefore, the perovskite layer prepared by the method provided in this example of the present application makes a perovskite cell have high stability and high photoelectric conversion efficiency.

In the above preparation method, the second precursor solution may form the second perovskite component in the passivation layer.

In the above preparation method, the first precursor solution may form the first perovskite component in the core portion. Or, the first precursor solution and the second precursor solution together form the first perovskite component in the core portion, whereby, in a crystallization process, a portion of the second precursor solution forms the second perovskite component in the passivation layer, and the other portion co-crystallizes with the first precursor solution to form the first perovskite component in the core portion.

A in the first precursor solution and A in the second precursor solution may be the same or different; X in the first precursor solution and X in the second precursor solution may be the same or different; X in the A-site precursor compound AX in the first precursor solution and X in the B-site precursor compound BX₂ may be the same or different; and X in the A-site precursor compound AX in the second precursor solution and X in PbX₂ may be the same or different. Those skilled in the art may make adjustments according to actual conditions.

In some examples, the third component may include one or more of dimethylphosphonic acid, 2,2-dimethylethyleneboronic acid, n-butylamine, glutaronitrile, 4-chlorobenzyl mercaptan, hydrocinnamic acid, and ethylsulfonic acid.

In some examples, the molar ratio of the third component to PbX₂ may be 0.005:1 to 0.1:1, optionally 0.01:1 to 0.05:1.

By adjusting the molar ratio of the third component to PbX₂ in the above range, the crystallized perovskite grain may have a complete passivation layer, for example, the passivation layer being located on 80-100% of the surface of the core portion, thereby helping to improve stability of a perovskite cell and also improve photoelectric conversion efficiency of a perovskite cell. When the molar ratio of the third component to PbX₂ is small, the passivation layer of the crystallized perovskite grain maybe not complete enough, which is not conducive to modifying grain boundary defects and surface defects of the perovskite crystal, and thus reduces stability of a prepared cell device. When the molar ratio of the third component to PbX₂ is large, the excess third component may complex with metal cations in the first perovskite component, which is not conducive to formation of a core-shell structured perovskite grain, and further not conducive to improving the stability of the cell device. In addition, the excessive third component may accumulate (or stack) on the surface and the grain boundary of the perovskite crystal, and thus increases an interface resistance of the perovskite layer, affects carrier transporting, and further affects photoelectric conversion efficiency of the cell device.

In some examples, the first solvent may include, but is not limited to, dimethylformamide (DMF) and dimethyl sulfoxide (DMSO). Optionally, the volume ratio of the DMF to the DMSO may be 2:1 to 9:1.

In some examples, the second solvent may include, but is not limited to, DMF and DMSO. Optionally, the volume ratio of the DMF to the DMSO may be 2:1 to 9:1.

In some examples, the step of removing the solvent from the thin film to form the perovskite layer includes the following step: the substrate with the thin film formed is transferred to a hot stage to perform annealing treatment to form the perovskite layer.

In some examples, the annealing temperature may be 80-210°C. When the annealing temperature is in the above range, the second perovskite component may form a complete passivation layer, and decomposition of the passivation layer may also be reduced.

In some examples, the annealing time may be 1-30 min. When the annealing time is in the above range, the second perovskite component may form a complete passivation layer, and decomposition of the passivation layer may also be reduced.

### [Perovskite cell]

In a fifth aspect, an example of the present application further provide a perovskite cell.

FIG. 2 is a schematic structural diagram of a perovskite cell provided in some examples of the present application.

As shown in FIG. 2, the perovskite cell includes a first electrode 1, a second electrode 5, a perovskite layer 3, a first charge transport layer 2, and a second charge transport layer 4. The first electrode 1 is close to a light incident side. The perovskite layer 3 is located between the first electrode 1 and the second electrode 5. The first charge transport layer 2 is located between the first electrode 1 and the perovskite layer 3. The second charge transport layer 4 is located between the second electrode 5 and the perovskite layer 3.

The perovskite layer 3 includes the perovskite layer provided in the third aspect of the examples of the present application, or a perovskite layer prepared by the method provided in the fourth aspect of the examples of the present application. Therefore, the perovskite cell provided in this example of the present application may have high stability and high photoelectric conversion efficiency.

The thickness of the perovskite layer 3 is not specifically limited, and may be selected based on actual requirements. In some examples, the thickness of the perovskite layer 3 may be 400-1,000 nm.

The perovskite cell provided in this example of the present application may be an n-i-p cell or a p-i-n cell.

In some examples, the first charge transport layer 2 is a hole transport layer, and the second charge transport layer 4 is an electron transport layer, thereby forming a p-i-n cell.

In some examples, the first charge transport layer 2 is an electron transport layer, and the second charge transport layer 4 is a hole transport layer, thereby forming an n-i-p cell.

The type of an electron transport material in the electron transport layer is not specifically limited, and may be selected based on actual requirements. For example, the electron transport material may include one or more of an organic electron transport material, an inorganic electron transport material, and an organic-inorganic hybrid electron transport material.

In some examples, the electron transport material may include, but is not limited to, one or more of the following materials and a derivative thereof, as well as materials obtained by doping or passivation: [6,6]-phenyl-C₆₁-butyric acid methyl ester (PC₆₁BM), [6,6]-phenyl-C₇₁-butyric acid methyl ester (PC₇₁BM), fullerene C60, fullerene C70, SnO₂, TiO₂, and ZnO. When the electron transport material is in the above range, the energy level of a conduction band bottom of the electron transport material can better match with that of a conduction band bottom of the perovskite layer, thereby helping to promoting electron transporting.

The thickness of the electron transport layer is not specifically limited, and may be selected based on actual requirements. For example, in some examples, the thickness of the electron transport layer may be 1-300 nm.

The type of the hole transport material in the hole transport layer is not specifically limited, and may be selected based on actual requirements. For example, the hole transport material may include one or more of a small organic molecule hole transport material, an organic polymer hole transport material, and an inorganic hole transport material.

In some examples, the hole transport material may include, but is not limited to, one or more of the following materials and a derivative thereof, as well as materials obtained by doping or passivation: poly[bis(4-phenyl)(2,4,6-trimethylphenyl)amine] (PTAA), poly(3-hexylthiophene) (P3HT), triphenylamine with triphenylene a core (H101), 3,4-ethylenedioxythiophene-methoxytriphenylamine (EDOT OMeTPA), N-(4-aniline)carbazole-spirobifluorene (CzPAF-SBF), poly(3,4-ethylenedioxythiophene):polystyrene sulfonic acid (PEDOT:PSS), 2,2',7,7'-tetra(N,N-p-methoxyphenylene)-9,9'-spirobifluorene (Spiro-OMeTAD), methoxytriphenylamine-fluoromethylamine (OMeTPA-FA), polythiophene, nickel oxide (NiOₓ, 0<x<1), molybdenum oxide (MoO₃), cuprous iodide (CuI), cuprous oxide (Cu₂O), and cuprous thiocyanate (CuSCN).

The thickness of the hole transport layer is not specifically limited, and may be selected based on actual requirements. For example, in some examples, the thickness of the hole transport layer may be 5-1,000 nm.

In some examples, the electrode material of the first electrode 1 may include an organic conductive material, an inorganic conductive material, or an organic-inorganic mixed conductive material. As an example, the electrode material of the first electrode 1 may include, but is not limited to, one or more of a first transparent conductive metal oxide, carbon, and a metal, optionally include one or more of fluorine-doped tin oxide (FTO), indium tin oxide (ITO), antimony-doped tin oxide (ATO), aluminum-doped zinc oxide (AZO), boron-doped zinc oxide (BZO), indium-doped zinc oxide (IZO), gold, silver, aluminum, copper, and carbon, and more optionally include one or more of fluorine-doped tin oxide (FTO), indium tin oxide (ITO), antimony-doped tin oxide (ATO), aluminum-doped zinc oxide (AZO), boron-doped zinc oxide (BZO), and indium-doped zinc oxide (IZO).

The thickness of the first electrode is not specifically limited, and may be selected based on actual requirements. For example, in some examples, the thickness of the first electrode 1 may be 10-700 nm.

In some examples, the electrode material of the second electrode 5 may include an organic conductive material, an inorganic conductive material, or an organic-inorganic mixed conductive material. As an example, the electrode material of the second electrode 5 may include, but is not limited to, one or more of a first transparent conductive metal oxide, carbon, and a metal, optionally include one or more of fluorine-doped tin oxide (FTO), indium tin oxide (ITO), antimony-doped tin oxide (ATO), aluminum-doped zinc oxide (AZO), boron-doped zinc oxide (BZO), indium-doped zinc oxide (IZO), gold, silver, aluminum, copper, and carbon, and more optionally include one or more of fluorine-doped tin oxide (FTO), indium tin oxide (ITO), antimony-doped tin oxide (ATO), aluminum-doped zinc oxide (AZO), boron-doped zinc oxide (BZO), and indium-doped zinc oxide (IZO).

The thickness of the second electrode is not specifically limited, and may be selected based on actual requirements. For example, in some examples, the thickness of the second electrode 5 may be 10-700 nm.

In some examples, the perovskite cell further includes a substrate, for example, a glass substrate, and a transparent metal conductive oxide may be arranged on a surface of the substrate.

The perovskite cell provided in this example of the present application is not limited to the above structure, and may further include other functional layers.

### [Method for preparing perovskite cell]

In a sixth aspect, an example of the present application further provides a method for preparing the perovskite cell provided in the fifth aspect of the examples of the present application.

The method includes the following steps: a first electrode is provided; a first charge transport layer is formed on the first electrode; a precursor solution for forming a perovskite layer is provided; the precursor solution for forming a perovskite layer is coated on the first charge transport layer to form a thin film; the solvent is removed from the thin film to form a perovskite layer; a second charge transport layer is formed on the perovskite layer; and a second electrode is formed on the second charge transport layer.

The precursor solution for forming a perovskite layer is obtained by mixing a first precursor solution and a second precursor solution. The first precursor solution includes a first solvent and an A-site precursor compound AX and a B-site precursor compound BX₂ dissolved in the first solvent, or includes a first solvent and an A-site precursor compound AX, a C-site precursor compound CX, and a D-site precursor compound DX₃ dissolved in the first solvent. The second precursor solution includes a second solvent and an A-site precursor compound AX, PbX₂, and a third component dissolved in the second solvent. The third component includes an alkyl group substituted with at least one of a sulfonic acid group, a phosphoric acid group, a carboxylic acid group, a boronic acid group, a cyano group, an amino group, a quaternary ammonium salt, and a mercapto group. The molecular size of the third component is greater than a first threshold, and the first threshold represents the maximum ionic radius of cations of the precursor compounds in the first precursor solution and the second precursor solution.

A perovskite layer of the perovskite cell includes a perovskite crystal, and the perovskite crystal includes one or more perovskite grains. The perovskite grain includes a core portion and a passivation layer located on at least part of a surface of the core portion. The core portion includes a first perovskite component, and the passivation layer includes a second perovskite component. The first perovskite component includes one or more of ABX₃ and A₂CDX₆, and the second perovskite component includes one or more of APbX₃. In ABX₃, A₂CDX₆, and APbX₃, A respectively and independently represents a monovalent inorganic cation, organic cation, or organic-inorganic mixed cation, and B represents a divalent inorganic cation, organic cation, or organic-inorganic mixed cation. In ABX₃, A₂CDX₆, and APbX₃, X respectively and independently represents a monovalent inorganic anion, organic anion, or organic-inorganic mixed anion, C represents a monovalent inorganic cation, organic cation, or organic-inorganic mixed cation, and D represents a trivalent inorganic cation, organic cation, or organic-inorganic mixed cation.

In some examples, the perovskite crystal further includes a third component located on a surface and/or a grain boundary of the perovskite crystal.

The third component in the second precursor solution may complex Pb²⁺, and the molecular size of the third component is greater than the maximum ionic radius of the cations of the precursor compounds in the first precursor solution and the second precursor solution. When a perovskite layer is formed by using the mixed precursor solution, the third component cannot be located at a cation position of the perovskite crystal due to a large molecular size of the third component, and thus the third component may exist as an impurity. During a crystallization process, the third component may be squeezed to the grain boundary and the surfaces of the perovskite crystal. Moreover, the third component contains the group that can coordinate or complex with Pb²⁺. Therefore, during a grain growth process, the third component may drive Pb²⁺ to separate and reach the grain boundary and the surface of the perovskite crystal, to form a core-shell structured perovskite grain. In addition, the passivation layer of the integrally formed perovskite grain may simultaneously passivate grain boundary defects and surface defects.

The first precursor solution and the second precursor solution are prepared separately, and the second precursor solution includes the third component, while the first precursor solution does not include the third component. This makes the third component complex with Pb²⁺ in the second precursor solution and reduces complexation of the third component with an optional metal cation in the first precursor solution, thereby integrally forming the core-shell structured perovskite grain during the crystallization process.

Therefore, the perovskite cell prepared by the method provided by this example of the present application may have high stability and high photoelectric conversion efficiency.

In the above preparation method, the second precursor solution may form the second perovskite component in the passivation layer.

In the above preparation method, the first precursor solution may form the first perovskite component in the core portion. Or, the first precursor solution and the second precursor solution together form the first perovskite component in the core portion, whereby, in a crystallization process, a portion of the second precursor solution forms the second perovskite component in the passivation layer, and the other portion co-crystallizes with the first precursor solution to form the first perovskite component in the core portion.

A in the first precursor solution and A in the second precursor solution may be the same or different; X in the first precursor solution and X in the second precursor solution may be the same or different; X in the A-site precursor compound AX in the first precursor solution and X in the B-site precursor compound BX₂ may be the same or different; and X in the A-site precursor compound AX in the second precursor solution and X in PbX₂ may be the same or different. Those skilled in the art may make adjustments according to actual conditions.

In some examples, the third component may include one or more of dimethylphosphonic acid, 2,2-dimethylethyleneboronic acid, n-butylamine, glutaronitrile, 4-chlorobenzyl mercaptan, hydrocinnamic acid, and ethylsulfonic acid.

In some examples, the molar ratio of the third component to PbX₂ may be 0.005:1 to 0.1:1, optionally 0.01:1 to 0.05:1.

By adjusting the molar ratio of the third component to PbX₂ in the above range, the crystallized perovskite grain may have a complete passivation layer, for example, the passivation layer being located on 80-100% of the surface of the core portion, thereby helping to improve stability of a perovskite cell and also improve photoelectric conversion efficiency of a perovskite cell. When the molar ratio of the third component to PbX₂ is small, the passivation layer of the crystallized perovskite grain maybe not complete enough, which is not conducive to modifying grain boundary defects and surface defects of the perovskite crystal, and thus reduces stability of a prepared cell device. When the molar ratio of the third component to PbX₂ is large, the excess third component may complex with metal cations in the first perovskite component, which is not conducive to formation of a core-shell structured perovskite grain, and further not conducive to improving the stability of the cell device. In addition, the excessive third component may accumulate (or stack) on the surface and the grain boundary of the perovskite crystal, and thus increases an interface resistance of the perovskite layer, affects carrier transporting, and further affects photoelectric conversion efficiency of the cell device.

In some examples, the first solvent may include, but is not limited to, dimethylformamide (DMF) and dimethyl sulfoxide (DMSO). Optionally, the volume ratio of the DMF to the DMSO may be 2:1 to 9:1.

In some examples, the second solvent may include, but is not limited to, DMF and DMSO. Optionally, the volume ratio of the DMF to the DMSO may be 2:1 to 9:1.

In some examples, the first electrode with the thin film formed is transferred to a hot stage to perform annealing treatment to form the perovskite layer.

In some examples, the annealing temperature is 80-210°C. When the annealing temperature is in the above range, the second perovskite component may form a complete passivation layer, and decomposition of the passivation layer may also be reduced.

In some examples, the annealing time is 1-30 min. When the annealing time is in the above range, the second perovskite component may form a complete passivation layer, and decomposition of the passivation layer may also be reduced.

A method for forming a film on the first electrode 1, the first charge transport layer 2, the second charge transport layer 4, and the second electrode 5 is not specifically limited and may use a film formation method known in the art, for example, chemical bath deposition, chemical vapor deposition, electrochemical deposition, physical epitaxial growth, thermal evaporation, atomic layer deposition, magnetron sputtering, precursor solution spin coating, precursor solution slit coating, precursor solution blade coating, mechanical pressing, sol-gel method, and pulsed laser deposition.

### [Perovskite layer]

In a seventh aspect, an example of the present application further provides another perovskite layer (referred to as perovskite layer II for differentiation), which can be used in a perovskite cell. Detailed description is provided below with reference to the drawings.

The perovskite layer includes a middle portion and a passivation portion located on at least part of a surface of the middle portion. The middle portion includes a perovskite crystal. The passivation portion includes a first passivation portion located on an upper and/or lower surface of the middle portion along a thickness direction, and a second passivation portion located on outer peripheral surfaces of the middle portion. The first passivation portion and the second passivation portion respectively and independently include a passivation material. The passivation material includes one or more of a lead-based perovskite material, lead sulfide, silicon carbide, an oxide, a polymer, and an small organic molecule.

By providing the passivation material on the upper surface and/or lower surface of the middle portion along the thickness direction and on the outer peripheral surfaces of the middle portion, a defect state density of the perovskite layer may be reduced, nonradiative recombination and impurity scattering can be reduced, and stability of a cell device can be improved. The lead-based perovskite material, lead sulfide, silicon carbide, oxide, polymer, and small organic molecule have passivation capabilities and may also transport carriers, thereby making a cell device have high photoelectric conversion efficiency.

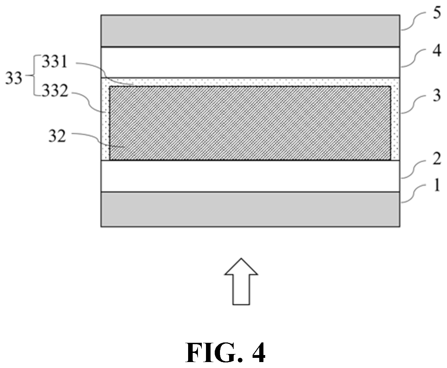

FIG. 3 and FIG. 4 are schematic structural diagrams of a perovskite cell using a perovskite layer II. A perovskite layer 3 includes a middle portion 32 and a passivation portion 33 located on at least part of a surface of the middle portion 32.

As shown in FIG. 3, in some examples, the passivation portion 33 may include a first passivation portion 331 located on both upper and lower surfaces of the middle portion 32 and a second passivation portion 332 located on outer peripheral surfaces of the middle portion 32.

As shown in FIG. 4, in some examples, the passivation portion 33 may include a first passivation portion 331 located on an upper surface of the middle portion 32 along a thickness direction, and a second passivation portion 332 located on outer peripheral surfaces of the middle portion 32.

In some other examples, the passivation portion 33 may also include a first passivation portion 331 located on a lower surface of the middle portion 32 along a thickness direction, and a second passivation portion 332 located on outer peripheral surfaces of the middle portion 32.

The upper surface of the middle portion along the thickness direction may be a surface of the middle portion along the thickness direction away from a light incident side, and the lower surface of the middle portion along the thickness direction may be a surface of the middle portion along the thickness direction close to the light incident side.

In some examples, the surface (i.e., the upper surface) of the middle portion along the thickness direction away from the light incident side and the outer peripheral surfaces of the middle portion are both provided with a passivation material. This may improve stability and oxidation resistance of a prepared cell device.

In some examples, the ratio of the thickness of the first passivation portion 331 to the thickness of the middle portion 32 is 1:5 to 1:20, optionally 1:6.5 to 1:15, or 1:6.5 to 1:12. This makes a perovskite cell have both high stability and high photoelectric conversion efficiency.

The thickness of the first passivation portion 331 refers to the thickness of the first passivation portion located on one of the two surfaces of the middle portion 32 along the thickness direction.

In some examples, the ratio of the thickness of the second passivation portion to the thickness of the middle portion 32 is 1:5 to 1:20, optionally 1:6.5 to 1:15, or 1:6.5 to 1:12. This makes a perovskite cell have both high stability and high photoelectric conversion efficiency.

The thickness of the second passivation portion 332 refers to the thickness of the second passivation portion located on one of four surfaces (i.e., outer peripheral surfaces) of the middle portion 32 along two directions perpendicular to the thickness direction.

In some examples, the thickness of the middle portion may be 400-1,000 nm.

In some examples, the oxides may include one or more of lead oxide, silicon oxide, aluminum oxide, and tin oxide. This not only improves stability of a cell device, but also promotes carrier transporting and improves photoelectric conversion efficiency of a cell device.

In some examples, the polymers may include one or more of homopolymers and copolymers of at least one monomer from vinyl chloride, thiophene and a derivative thereof, carbazole and a derivative thereof, and styrene sulfonic acid. For example, the polymers may include one or more of polyvinyl chloride, polythiophene, polycarbazole, poly(3,4-ethylenedioxythiophene), and poly (styrenesulfonic acid). This makes a perovskite cell have both high stability and high photoelectric conversion efficiency.

In some examples, the small organic molecule may include a compound containing at least one of a halogen atom and a heteroatom, and the heteroatom includes one or more of N, S, and O. Optionally, the molecular weight of the small organic molecule is less than 2,000.

The small organic molecule includes the halogen atom and/or the heteroatom, and the halogen atom and the heteroatom have greater electronegativity and higher charge density, and may interact with a metal cation in a perovskite crystal to form a ligand. The molecular size of the small organic molecule is typically larger than the maximum ionic radius of the cations in the perovskite crystal, and thus the small organic molecule does not easily enter a crystal lattice of the perovskite crystal. Therefore, when the perovskite layer is crystallized, the small organic molecule may exist as an impurity and may be separate and reach to a grain boundary and a surface of the perovskite crystal, playing a role in passivating grain boundary defects and surface defects.

In some examples, the small organic molecule may include one or more of alkylamine and a derivative thereof, aromatic amine and a derivative thereof, a nitrogen heterocyclic compound and a derivative thereof, thiophene and a derivative thereof, carbazole and a derivative thereof, iodopentafluorobenzene and a derivative thereof. A derivative of a compound typically refers to a substance obtained by substituting an atom or an atomic group in the compound with another atom or atomic group. As an example, the small organic molecule may include one or more of phenylethylammonium iodide, 2-(4-fluorophenyl)ethylamine hydroiodide, isobutylamine, 1-aminopentane, trimethylammonium bromide, tetramethylphosphonic acid carbazole, vinylcarbazole, 3,4-ethylenedioxythiophene, and styrene sulfonate. This makes a perovskite cell have both high stability and high photoelectric conversion efficiency.

In some examples, the perovskite crystal in the middle portion may include the perovskite crystal provided in the first aspect of the examples of the present application.

### [Perovskite cell]

In an eighth aspect, an example of the present application further provides another perovskite cell.

As shown in FIG. 3 and FIG. 4, the perovskite cell includes a first electrode 1, a second electrode 5, a perovskite layer 3, a first charge transport layer 2, and a second charge transport layer 4. The first electrode 1 is close to a light incident side. The perovskite layer 3 is located between the first electrode 1 and the second electrode 5. The first charge transport layer 2 is located between the first electrode 1 and the perovskite layer 3. The second charge transport layer 4 is located between the second electrode 5 and the perovskite layer 3. The perovskite layer 3 includes the perovskite layer (i.e., the perovskite layer II) provided in the seventh aspect of the examples of the present application. Therefore, the perovskite cell may have high stability and high photoelectric conversion efficiency.

In some examples, the first charge transport layer 2 is a hole transport layer, the second charge transport layer 4 is an electron transport layer, and a LUMO energy level of the first passivation portion 331 is lower than a CBM energy level of the middle portion 32. This helps to promote carrier transporting, and also helps to improve photoelectric conversion efficiency of a cell device.

In some examples, the first charge transport layer 2 is an electron transport layer, the second charge transport layer 4 is a hole transport layer, and a HOMO energy level of the first passivation portion 331 is greater than a VBM energy level of the middle portion 32. This helps to promote carrier transporting, and also helps to improve photoelectric conversion efficiency of a cell device.

In some examples, the first charge transport layer 2 is a hole transport layer, and the second charge transport layer 4 is an electron transport layer. The passivation portion 33 includes a first passivation portion 331 located on a surface of the middle portion 32 away from the first charge transport layer 2, and a second passivation portion 332 located on an outer peripheral surface of the middle portion 32, and a LUMO energy level of the first passivation portion 331 is lower than a CBM energy level of the middle portion 32. This helps to promote carrier transporting, and also helps to improve photoelectric conversion efficiency of a cell device.

In some examples, the first charge transport layer 2 is an electron transport layer, and the second charge transport layer 4 is a hole transport layer. The passivation portion 33 includes a first passivation portion 331 located on a surface of the middle portion 32 away from the first charge transport layer 2, and a second passivation portion 332 located on outer peripheral surfaces of the middle portion 32, and a HUMO energy level of the first passivation portion 331 is greater than a VBM energy level of the middle portion 32. This helps to promote carrier transporting, and also helps to improve photoelectric conversion efficiency of a cell device.

The perovskite cell provided in the fifth aspect of the examples of the present application may be referred to for other components and structures of the perovskite cell, and descriptions thereof are omitted herein.

### [Method for preparing perovskite cell]

In a ninth aspect, an example of the present application further provides a method for preparing the perovskite cell provided in the eighth aspect of the examples of the present application.

The method includes the following steps: a first electrode is provided; a first charge transport layer is formed on the first electrode; a perovskite layer is formed on the first charge transport layer; a second charge transport layer is formed on the perovskite layer; and a second electrode is formed on the second charge transport layer.

In some examples, a method for forming the perovskite layer on the first charge transport layer includes a solution method, a hydrothermal method, a vapor deposition method, and the like.

In some examples, the step of forming the perovskite layer on the first charge transport layer includes the following steps: a passivation material and a precursor solution for forming the middle portion are provided; and the passivation material is mixed with the precursor solution for forming the middle portion and the mixture is applied to the first charge transport layer to form the perovskite layer. The molar ratio of the passivation material to the precursor (i.e., a perovskite crystal) for forming the middle portion is 0.01:1 to 0.25:1, optionally 0.01:1 to 0.1:1.

By adjusting the molar ratio of the passivation material to the precursor for forming the middle portion in the above range, the first passivation portion may be formed on the upper surface and/or lower surface of the middle portion along the thickness direction, and the second passivation portion can be formed on the outer peripheral surfaces of the middle portion simultaneously.

In some examples, the step of forming the perovskite layer on the first charge transport layer includes the following steps: a precursor solution for forming a middle portion is provided, wherein the precursor solution for forming a middle portion is obtained by mixing a first precursor solution and a second precursor solution; the first precursor solution includes a first solvent and an A-site precursor compound AX and a B-site precursor compound BX₂ dissolved in the first solvent, or includes a first solvent and an A-site precursor compound AX, a C-site precursor compound CX, and a D-site precursor compound DX₃ dissolved in the first solvent; the second precursor solution includes a second solvent and an A-site precursor compound AX, PbX₂, and a third component dissolved in the second solvent, the third component includes an alkyl group substituted with at least one of a sulfonic acid group, a phosphoric acid group, a carboxylic acid group, a boric acid group, a cyano group, an amino group, a quaternary ammonium salt, and a mercapto group, the molecular size of the third component is greater than a first threshold, and the first threshold represents the maximum ionic radius of cations of the precursor compounds in the first precursor solution and the second precursor solution; the precursor solution for forming a middle portion is coated on the first charge transport layer to form a thin film; the solvent is removed from the thin film to form a middle portion; and a passivation material provided by the examples of the present application is applied to an upper surface and outer peripheral surfaces of the middle portion to complete preparation of the perovskite layer.

Thus, the perovskite crystal formed in the middle portion may include the perovskite crystal provided in the first aspect of the examples of the present application.

Optionally, a method for applying the passivation material to the upper surface and the outer peripheral surfaces of the middle portion includes a vapor deposition method.

In some examples, before the precursor solution for forming the middle portion is coated on the first charge transport layer to form the thin film, the method further includes a step of: a passivation material provided by the examples of the present application is applied to the first charge transport layer.

Optionally, a method for applying the passivation material to the first charge transport layer includes a vapor deposition method.

A method for forming a film on the first electrode 1, the first charge transport layer 2, the second charge transport layer 4, and the second electrode 5 is not specifically limited and may use a film formation method known in the art, for example, chemical bath deposition, chemical vapor deposition, electrochemical deposition, physical epitaxial growth, thermal evaporation, atomic layer deposition, magnetron sputtering, precursor solution spin coating, precursor solution slit coating, precursor solution blade coating, mechanical pressing, sol-gel method, and pulsed laser deposition.

The perovskite cell provided in this example of the present application may be used alone as a single-junction perovskite cell, or may be combined with a perovskite type or other types of perovskite cells to form a stacked cell, for example, a perovskite-perovskite stacked cell or a perovskite-crystalline silicon stacked cell.

### [Photovoltaic module]

An example of the present application further provides a photovoltaic module. The photovoltaic module includes the perovskite cell provided in the examples of the present application or the perovskite cell prepared by the method provided in the examples of the present application, and the perovskite cell may be used as a power source for the photovoltaic module after processes such as series-parallel connection and encapsulation.

In some examples, the photovoltaic module includes the single-junction perovskite cell, the perovskite-perovskite stacked cell, or the perovskite-crystalline silicon stacked cell provided in the examples of the present application.

### [Electrical apparatus]

An example of the present application further provides an electrical apparatus. The electrical apparatus includes one or more of the perovskite cell provided in the examples of the present application, the perovskite cell prepared by the method provided in the examples of the present application, and the photovoltaic module provided in the examples of the present application, wherein the perovskite cell and the photovoltaic module may be used to supply power to the electrical apparatus.

In some examples, the electrical apparatus may be a common device including the perovskite cell or the photovoltaic module provided in the examples of the present application, for example, a device used in the fields of communications, transportation, industry, agriculture, and lighting. As an example, the electrical apparatus may include a satellite, a communication device, a traffic light, a lighthouse, a wireless phone booth, a monitoring device for the field of oil drilling, a power supply system, a camping lantern, an electric vehicle, a charger for an electronic device, and the like.

### Examples

The following Examples more specifically describe the contents disclosed in the present application. These Examples are intended for illustrative purposes only, because various modifications and changes made within the scope of the contents disclosed in the present application will be apparent to those skilled in the art. Unless otherwise stated, all parts, percentages, and ratios reported in the following Examples are based on weight, all reagents used in the Examples are either commercially available or synthesized according to conventional methods, and may be directly used without further processing, and all the instruments used in the Examples are commercially available.

### Example 1-1

### Preparation of first electrode

A piece of 2.0 cm×2.0 cm FTO conductive glass was taken, and 0.35 cm of FTO was removed from both ends via laser etching to expose a glass substrate. The laser-etched FTO conductive glass was ultrasonically cleaned multiple times sequentially with water, acetone, and isopropanol. A solvent on the cleaned FTO conductive glass was blow-dried under a nitrogen gun, and then the FTO conductive glass was further cleaned in an ultraviolet ozone machine for later use.

### Preparation of hole transport layer

The FTO conductive glass was placed on a suction cup, and a PEDOT:PSS aqueous solution was spin-coated on the FTO conductive glass at a speed of 5,000 rpm for 30 s. The FTO conductive glass was then placed on a heating table and annealed at 150°C for 10 min. After cooling to room temperature (25°C), a hole transport layer with a thickness of 50 nm was obtained and placed in an ultra-purified glove box filled with nitrogen.

### Preparation of perovskite layer

335 mg of SnI₂ and 216 mg of formamidine iodide (FAI) were dissolved in a mixed solvent of dimethylformamide (DMF) and dimethyl sulfoxide (DMSO) (in a volume ratio of 4:1) to obtain a formamidine tin iodide (FASnI₃) precursor solution, wherein the concentration of FASnI₃ was 1 mol/L. 414 mg of PbI₂ and 85 mg of methylamine iodide (MAI) were dissolved in a mixed solvent of dimethyl phosphonic acid, DMF, and DMSO to obtain a methylamine lead iodide (MAPbI₃) precursor solution, wherein the concentration of the MAPbI₃ was 1 mol/L, the volume ratio of the DMF to the DMSO was 4:1, and the molar ratio of the dimethyl phosphonic acid to the PbI₂ was 0.02:1. The FASnI₃ precursor solution and the MAPbI₃ precursor solution were mixed by stirring to obtain a precursor solution.

The precursor solution was spin-coated on the hole transport layer at a speed of 1,000 rpm for 10 s and then at a speed of 4,000 rpm for 40 s. 400 µL of chlorobenzene was quickly added at the 30th second. After that, the hole transport layer was annealed at 100°C for 10 min and cooled to room temperature to obtain a perovskite layer with a thickness of 800 nm. A perovskite grain in the perovskite layer included a core portion and a passivation layer located on at least part of a surface of the core portion. A perovskite component in the core portion was a tin lead mixed perovskite material, and a perovskite component in the passivation layer was a lead-based perovskite material, namely MAPbI₃.

### Preparation of electron transport layer

40 µL of a PCBM solution was spin-coated on a surface of the perovskite layer at 4,000 rpm for 30 s to obtain an electron transport layer with a thickness of 25 nm, and then a BCP layer with a thickness of 15 nm was evaporated.

### Preparation of second electrode

The obtained sample was placed in a thermal evaporator, and an Ag electrode with a thickness of 10 nm was evaporated to obtain a cell device.

### Examples 1-2 to 1-6

Preparation of a cell device was the same as that of Example 1-1, except that the molar ratio of dimethylphosphonic acid to PbI₂ was different when a methylamine lead iodide (MAPbI₃) precursor solution was prepared. Specific parameters are shown in Table 1.

### Examples 1-7 to 1-11

Preparation of a cell device was the same as that of Example 1-1, except that a different third component was used when a methylamine lead iodide (MAPbI₃) precursor solution was prepared. Specific types of the third component are shown in Table 1.

### Comparative Example 1-1

Except for a difference in preparation of a passivation layer, preparation of a cell device was the same as that of Example 1-1.

335 mg of SnI₂ and 216 mg of formamidine iodide (FAI) were dissolved in a mixed solvent of dimethylformamide (DMF) and dimethyl sulfoxide (DMSO) (in a volume ratio of 4:1) to obtain a formamidine tin iodide (FASnI₃) precursor solution, wherein the concentration of FASnI₃ was 1 mol/L. 414 mg of PbI₂ and 85 mg of methylamine iodide (MAI) were dissolved in a mixed solvent of DMF and DMSO (in a volume ratio of 4:1) to obtain a methylamine lead iodide (MAPbI₃) precursor solution, wherein the concentration of MAPbI₃ was 1 mol/L. The FASnI₃ precursor solution and the MAPbI₃ precursor solution were mixed by stirring to obtain a (FASnI₃)_{0.5}(MAPbI₃)_{0.5} precursor solution.

The (FASnI₃)_{0.5}(MAPbI₃)_{0.5} precursor solution was spin-coated on the hole transport layer at a speed of 1,000 rpm for 10 s and then at a speed of 4,000 rpm for 40 s. 400 µL of chlorobenzene was quickly added at the 30th second. After that, the hole transport layer was annealed at 100°C for 10 min and cooled to room temperature to obtain a perovskite layer.

### Comparative Example 1-2

Except for a difference in preparation of a passivation layer, preparation of a cell device was the same as that of Example 1-1.

The prepared FTO/PEDOT:PS substrate was placed in an evaporator, and then 335 mg of stannous iodide (evaporation source 1), 216 mg of formamidine iodide (evaporation source 2), 414 mg of lead iodide (evaporation source 3), 85 mg of methylamine iodide (evaporation source 4), 100 mg of lead iodide (evaporation source 5), and 32 mg of methylamine iodide (evaporation source 6) were added to different evaporation sources.

The stannous iodide in the evaporation source 1 and the lead iodide in the evaporation source 3 were heated and evaporated at 270°C to deposit onto the substrate. The formamidine iodide in the evaporation source 2 and the methylamine iodide in the evaporation source 4 were then heated and evaporated at 140°C to deposit onto the substrate. After the deposition, the substrate was annealed at 100°C for 10 min in a nitrogen environment to obtain MA_{0.5}FA_{0.5}Pb_{0.5}Sn_{0.5}I₃. Afterwards, the lead iodide in the evaporation source 5 was heated and evaporated at 270°C to deposit onto the MA_{0.5}FA_{0.5}Pb_{0.5}Sn_{0.5}I₃, and the methylamine iodide in the evaporation source 6 was heated and evaporated at 140°C to deposit onto the MA_{0.5}FA_{0.5}Pb_{0.5}Sn_{0.5}I₃. After the deposition, the MA_{0.5}FA_{0.5}Pb_{0.5}Sn_{0.5}I₃ was annealed at 100°C for 10 min in a nitrogen environment to obtain a perovskite layer. A perovskite grain in the perovskite layer included a core portion and a passivation layer located on at least part of a surface of the core portion. A perovskite component in the core portion was MA_{0.5}FA_{0.5}Pb_{0.5}Sn_{0.5}I₃, and a perovskite component in the passivation layer was MAPbI₃.

The performance of the cell devices provided in Examples 1-1 to 1-11 and Comparative Examples 1-1 to 1-2 was tested. The test results are shown in Table 1.

IEC61215 was referred to as a test standard. A crystalline silicon solar cell was used to correct a light intensity to one solar intensity, AM 1.5. During the test, a cell device were connected to a digital source meter and tested under light to obtain an I-V curve. A short-circuit current Jsc (in mA/cm²), an open-circuit voltage Voc (in V), the maximum light output current Jmpp (in mA), and the maximum light output voltage Vmpp (in V) were obtained according to the I-V curve and data fed back by a test device. A fill factor FF (in %) of the perovskite cell was calculated using a formula FF=Jsc×Voc/(Jmpp×Vmpp). A photoelectric conversion efficiency PCE (in %) of the perovskite cell was calculated by a formula PCE=(Jsc×Voc×FF)/Pw, wherein Pw represents an input power in mW.

A solar simulator (Enlitech) may be used as a test instrument.

**Table 1**

| No. | Type of third component | Molar ratio of third component to PbI₂ | Thickness of passivation layer (nm) | Thickness of passivation layer: grain size of perovskite grain | Photovoltaic conversion efficiency PCE₃ on the 3rd day | Photovoltaic conversion efficiency on the 30th day PCE₃₀ | PCE₃₀/ PCE₃ |
|---|---|---|---|---|---|---|---|
| Example 1-1 | Dimethylphosphonic acid | 0.02:1 | 28 | 0.050:1 | 21.52% | 20.82% | 96.75% |
| Example 1-2 | Dimethylphosphonic acid | 0.01:1 | 15 | 0.028:1 | 20.12% | 18.98% | 94.33% |
| Example 1-3 | Dimethylphosphonic acid | 0.05:1 | 56 | 0.14:1 | 20.13% | 19.63% | 97.52% |
| Example 1-4 | Dimethylphosphonic acid | 0.08:1 | 71 | 0.17:1 | 19.34% | 18.97% | 98.09% |
| Example 1-5 | Dimethylphosphonic acid | 0.1:1 | 94 | 0.23:1 | 18.23% | 18.03% | 98.90% |
| Example 1-6 | Dimethylphosphonic acid | 0.005:1 | 10 | 0.020:1 | 18.52% | 17.20% | 92.87% |
| Example 1-7 | N-butylamine | 0.02:1 | 19 | 0.051:1 | 18.90% | 15.65% | 82.80% |
| Example 1-8 | Glutaronitrile | 0.02:1 | 28 | 0.063:1 | 20.09% | 17.09% | 85.07% |
| Example 1-9 | 4-chlorobenzyl mercaptan | 0.02:1 | 24 | 0.053:1 | 19.18% | 16.21% | 84.52% |
| Example 1-10 | Hydrocinnamic acid | 0.02:1 | 20 | 0.042:1 | 18.23% | 15.08% | 82.72% |
| Example 1-11 | 2,2-dimethylethyleneboronic acid | 0.02:1 | 34 | 0.080:1 | 19.28% | 17.80% | 92.32% |
| Comparative Example 1-1 | / | / | / | / | 18.05% | 13.27% | 73.52% |
| Comparative Example 1-2 | / | / | 57 | 0.14:1 | 17.98% | 14.15% | 78.70% |

From the test results of Examples 1-1 to 1-11 and Comparative Example 1-1, when a core-shell structured perovskite grain is integrally formed, a perovskite cell may have high stability and high photoelectric conversion efficiency.

From the test results of Comparative Example 1-2, when a passivation layer is formed by vapor deposition on a surface of a tin-lead mixed perovskite grain prepared, an interface may be formed between a core portion and a shell portion of the finally prepared perovskite grain. The existence of the interface may affect carrier transporting, and stability of a perovskite crystal is not obviously improved. Therefore, the perovskite cell prepared in Comparative Example 1-2 has relatively low stability and photoelectric conversion efficiency.

### Example 2-1

Except for a difference in preparation of a passivation layer, preparation of a cell device was the same as that of Example 1-1.

### Preparation of perovskite layer

335 mg of SnI₂ and 216 mg of formamidine iodide (FAI) were dissolved in a mixed solvent of dimethylformamide (DMF) and dimethyl sulfoxide (DMSO) (in a volume ratio of 4:1) to obtain a formamidine tin iodide (FASnI₃) precursor solution, wherein the concentration of FASnI₃ was 1 mol/L. 414 mg of PbI₂ and 85 mg of methylamine iodide (MAI) were dissolved in a mixed solvent of DMF and DMSO (in a volume ratio of 4:1) to obtain a methylamine lead iodide (MAPbI₃) precursor solution, wherein the concentration of MAPbI₃ was 1 mol/L. The FASnI₃ precursor solution and the MAPbI₃ precursor solution were mixed by stirring, 3 ml of a PbS colloidal quantum dot solution dissolved in n-octane was added and stirred for 10 min, and the n-octane was washed off from the solution with isopropanol to obtain a (FASnI₃)_{0.5}(MAPbI₃)_{0.5} precursor solution.

The (FASnI₃)_{0.5}(MAPbI₃)_{0.5} precursor solution was spin-coated on the hole transport layer at a speed of 1,000 rpm for 10 s and then at a speed of 4,000 rpm for 40 s. 400 µL of chlorobenzene was quickly added at the 30th second. After that, the hole transport layer was annealed at 100°C for 10 min and cooled to room temperature to obtain a perovskite layer.

The perovskite layer included a middle portion and a passivation portion. The passivation portion included a first passivation portion located on upper and lower surfaces of the middle portion along a thickness direction, and a second passivation portion located on outer peripheral surfaces of the middle portion.

### Examples 2-2 to 2-5

Preparation of cell devices was the same as that of Example 2-1, except that the amount of a PbS colloidal quantum dot solution was different when the (FASnI₃)_{0.5}(MAPbI₃)_{0.5} precursor solution was prepared. Specific parameters are shown in Table 2.

### Examples 2-6 to 2-10

Preparation of cell devices was the same as that of Example 2-1, except that a different passivation material was used when the (FASnI₃)_{0.5}(MAPbI₃)_{0.5} precursor solution was prepared. Specific parameters are shown in Table 2.

### Comparative Example 2-1

Preparation of a cell device was the same as that of Example 2-1, except that the amount of a PbS colloidal quantum dot solution was different when the (FASnI₃)_{0.5}(MAPbI₃)_{0.5} precursor solution was prepared. Specific parameters are shown in Table 2.

The performance of the cell devices provided in Examples 2-1 to 2-10 and Comparative Example 2-1 was tested. The test results are shown in Table 2.

**Table 2**

| No. | Passivation material | Molar ratio of passivation material to (FASnI₃)_{0.5} (MAPbI₃)_{0.5} | Position of passivation portion | Thickness of first passivation portion: thickness of middle portion |
|---|---|---|---|---|
| Example 2-1 | PbS | 0.025:1 | Upper surface, lower surface, and outer peripheral surface | 1:10 |
| Example 2-2 | PbS | 0.05:1 | Upper surface, lower surface, and outer peripheral surface | 1:8.5 |
| Example 2-3 | PbS | 0.10:1 | Upper surface, lower surface, and outer peripheral surface | 1:7.3 |
| Example 2-4 | PbS | 0.25:1 | Upper surface, lower surface, and outer peripheral surface | 1:5.2 |
| Example 2-5 | PbS | 0.01:1 | Upper surface, lower surface, and outer peripheral surface | 1:20 |
| Example 2-6 | CsPbBr₃ | 0.025:1 | Upper surface, lower surface, and outer peripheral surface | 1:9.1 |
| Example 2-7 | Lead oxide | 0.025:1 | Upper surface, lower surface, and outer peripheral surface | 1:8.4 |
| Example 2-8 | Aluminum oxide | 0.025:1 | Upper surface, lower surface, and outer peripheral surface | 1:9.4 |
| Example 2-9 | Tetramethylphosphonic acid carbazole | 0.025:1 | Upper surface, lower surface, and outer peripheral surface | 1:8.2 |
| Example 2-10 | Polyvinyl chloride | 0.025:1 | Upper surface, lower surface, and outer peripheral surface | 1:7.3 |
| Comparative Example 2-1 | PbS | 0.005:1 | Upper surface and lower surface | 1:18 |

| No. | Thickness of second passivation portion: thickness of middle portion | Photovoltaic conversion efficiencyPCE₃on the 3rd day | Photovoltaic conversion efficiency on the 30th day PCE₃₀ | PCE₃₀/ PCE₃ |
|---|---|---|---|---|
| Example 2-1 | 1:10 | 20.83% | 20.04% | 96.21% |
| Example 2-2 | 1:8.2 | 20.07% | 19.55% | 97.41% |
| Example 2-3 | 1:6.8 | 19.59% | 19.19% | 97.96% |
| Example 2-4 | 1:5 | 18.31% | 17.99% | 98.25% |
| Example 2-5 | 1:18 | 19.15% | 17.94% | 93.68% |
| Example 2-6 | 1:8.5 | 19.56% | 18.10% | 92.54% |
| Example 2-7 | 1:7.3 | 19.34% | 17.80% | 92.04% |
| Example 2-8 | 1:7.6 | 19.10% | 17.57% | 91.99% |
| Example 2-9 | 1:7.5 | 21.25% | 20.18% | 94.96% |
| Example 2-10 | 1:6.5 | 19.21% | 17.30% | 90.06% |
| Comparative Example 2-1 | 0 | 18.18% | 14.19% | 78.04% |

From the test results in Table 2, when the upper and/or lower surface of the middle portion along the thickness direction, and also the outer peripheral surfaces of the middle portion of the perovskite layer are provided with the passivation material, the perovskite cell may have high stability and high photoelectric conversion efficiency.

From the test results of Comparative Example 2-1, when the outer peripheral surfaces of the perovskite layer are not provided the passivation material, the perovskite cell prepared has relatively low stability and photoelectric conversion efficiency.

The above descriptions are merely specific embodiments of the present application, and the protection scope of the present application is not limited thereto. It would be easy for any person familiar with the art to arrive at various modifications or replacements within the technical scope disclosed in the present application, and the modifications or replacements should be covered by the protection scope of the present application. Therefore, the protection scope of the present application should be based on the protection scope of the claims.

## Claims

1. A perovskite crystal, wherein
the perovskite crystal comprises one or more perovskite grains; the perovskite grain comprises a core portion and a passivation layer located on at least part of a surface of the core portion;
the core portion comprises a first perovskite component; the passivation layer comprises a second perovskite component; the first perovskite component comprises one or more of ABX₃ and A₂CDX₆; the second perovskite component comprises one or more of APbX₃; in ABX₃, A₂CDX₆, and APbX₃, A respectively and independently represents a monovalent inorganic cation, organic cation, or organic-inorganic mixed cation, and B represents a divalent inorganic cation, organic cation, or organic-inorganic mixed cation; in ABX₃, A₂CDX₆, and APbX₃, X respectively and independently represents a monovalent inorganic anion, organic anion, or organic-inorganic mixed anion, C represents a monovalent inorganic cation, organic cation, or organic-inorganic mixed cation, and D represents a trivalent inorganic cation, organic cation, or organic-inorganic mixed cation.

2. The perovskite crystal according to claim 1, wherein the passivation layer and the core portion.

3. The perovskite crystal according to any one of claims 1 to 2, wherein the perovskite crystal further comprises a third component, the third component is located on a surface and/or a grain boundary of the perovskite crystal, the third component comprises an alkyl group substituted with at least one of a sulfonic acid group, a phosphoric acid group, a carboxylic acid group, a boronic acid group, a cyano group, an amino group, a quaternary ammonium salt, and a mercapto group, the molecular size of the third component is greater than a first threshold, and the first threshold represents the maximum ionic radius of the cations of the first perovskite component and the second perovskite component.

4. The perovskite crystal according to claim 3, wherein the third component comprises one or more of dimethylphosphonic acid, 2,2-dimethylethyleneboronic acid, n-butylamine, glutaronitrile, 4-chlorobenzyl mercaptan, hydrocinnamic acid, and ethylsulfonic acid.

5. The perovskite crystal according to any one of claims 1 to 4, wherein
the ratio of the thickness of the passivation layer to a grain size of the perovskite grain is greater than 0 and less than or equal to 0.33:1; and/or,
the thickness of the passivation layer is 1-100 nm.

6. The perovskite crystal according to any one of claims 1 to 5, wherein
the grain size of the perovskite grain is 300-1,000 nm; and/or,
the passivation layer is located on 80-100% of the surface of the core portion.

7. The perovskite crystal according to any one of claims 1 to 6, wherein B comprises one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺.

8. The perovskite crystal according to any one of claims 1 to 7, wherein
A in ABX₃, A₂CDX₆, and APbX₃ respectively and independently comprises one or more of CH₃NH₃⁺, CH₃CH₂NH₃⁺, CH(NH₂)₂⁺, Li⁺, Na⁺, K⁺, Rb⁺, and Cs⁺; and/or,
X in ABX₃, A₂CDX₆, and APbX₃ respectively and independently represents a halogen ion; and/or,
C represents a monovalent metal cation; and/or,
D represents a trivalent metal cation.

9. A precursor solution for preparing the perovskite crystal according to any one of claims 1 to 8, wherein
the precursor solution is obtained by mixing a first precursor solution and a second precursor solution;
the first precursor solution comprises a first solvent and an A-site precursor compound AX and a B-site precursor compound BX₂ dissolved in the first solvent, or comprises a first solvent and an A-site precursor compound AX, a C-site precursor compound CX, and a D-site precursor compound DX₃ dissolved in the first solvent; and
the second precursor solution comprises a second solvent and an A-site precursor compound AX, PbX₂, and a third component dissolved in the second solvent, the third component comprises an alkyl group substituted with at least one of a sulfonic acid group, a phosphoric acid group, a carboxylic acid group, a boronic acid group, a cyano group, an amino group, a quaternary ammonium salt, and a mercapto group, the molecular size of the third component is greater than a first threshold, and the first threshold represents the maximum ionic radius of cations of the precursor compounds in the first precursor solution and the second precursor solution.

10. The precursor solution according to claim 9, wherein
the third component comprises one or more of dimethylphosphonic acid, 2,2-dimethylethyleneboronic acid, n-butylamine, glutaronitrile, 4-chlorobenzyl mercaptan, hydrocinnamic acid, and ethylsulfonic acid; and/or,
the molar ratio of the third component to PbX₂ is 0.005:1 to 0.1:1; and/or,
the first solvent comprises dimethylformamide and dimethyl sulfoxide; and/or,
the second solvent comprises dimethylformamide and dimethyl sulfoxide.

11. A perovskite layer, wherein the perovskite layer comprises the perovskite crystal according to any one of claims 1 to 8.

12. A method for preparing a perovskite layer, comprising the following steps:
providing a substrate;
providing a precursor solution for forming a perovskite layer, wherein the precursor solution for forming a perovskite layer is obtained by mixing a first precursor solution and a second precursor solution; the first precursor solution comprises a first solvent and an A-site precursor compound AX and a B-site precursor compound BX₂ dissolved in the first solvent, or comprises a first solvent and an A-site precursor compound AX, a C-site precursor compound CX, and a D-site precursor compound DX₃ dissolved in the first solvent; and the second precursor solution comprises a second solvent and an A-site precursor compound AX, PbX₂, and a third component dissolved in the second solvent, the third component comprises an alkyl group substituted with at least one of a sulfonic acid group, a phosphoric acid group, a carboxylic acid group, a boronic acid group, a cyano group, an amino group, a quaternary ammonium salt, and a mercapto group, the molecular size of the third component is greater than a first threshold, and the first threshold represents the maximum ionic radius of cations of the precursor compounds in the first precursor solution and the second precursor solution;
coating the precursor solution for forming a perovskite layer on the substrate to form a thin film; and
removing the solvent from the thin film to form a perovskite layer, wherein the perovskite layer comprises a perovskite crystal, and the perovskite crystal comprises one or more perovskite grains; the perovskite grain comprises a core portion and a passivation layer located on at least part of a surface of the core portion; the core portion comprises a first perovskite component; the passivation layer comprises a second perovskite component; the first perovskite component comprises one or more of ABX₃ and A₂CDX₆; the second perovskite component comprises one or more of APbX₃; in ABX₃, A₂CDX₆, and APbX₃, A respectively and independently represents a monovalent inorganic cation, organic cation, or organic-inorganic mixed cation, and B represents a divalent inorganic cation, organic cation, or organic-inorganic mixed cation; in ABX₃, A₂CDX₆, and APbX₃, X respectively and independently represents a monovalent inorganic anion, organic anion, or organic-inorganic mixed anion, C represents a monovalent inorganic cation, organic cation, or organic-inorganic mixed cation, and D represents a trivalent inorganic cation, organic cation, or organic-inorganic mixed cation.

13. The method according to claim 12, wherein
the third component comprises one or more of dimethylphosphonic acid, 2,2-dimethylethyleneboronic acid, n-butylamine, glutaronitrile, 4-chlorobenzyl mercaptan, hydrocinnamic acid, and ethylsulfonic acid; and/or,
the molar ratio of the third component to PbX₂ is 0.005:1 to 0.1:1; and/or,
the first solvent comprises dimethylformamide and dimethyl sulfoxide; and/or,
the second solvent comprises dimethylformamide and dimethyl sulfoxide.

14. The method according to any one of claims 12 to 13, wherein the step of removing the solvent from the thin film to form the perovskite layer comprises the following step: transferring the substrate with the thin film formed to a hot stage to perform annealing treatment to form the perovskite layer.

15. A perovskite cell, comprising:
a first electrode, close to a light incident side;
a second electrode;
a perovskite layer, located between the first electrode and the second electrode;
a first charge transport layer, located between the first electrode and the perovskite layer; and
a second charge transport layer, located between the second electrode and the perovskite layer;
wherein
the perovskite layer comprises the perovskite layer according to claim 10, or a perovskite layer prepared by the method according to any one of claims 12 to 14.

16. A method for preparing a perovskite cell, comprising the following steps:
providing a first electrode;
forming a first charge transport layer on the first electrode;
providing a precursor solution for forming a perovskite layer, wherein the precursor solution for forming a perovskite layer is obtained by mixing a first precursor solution and a second precursor solution; the first precursor solution comprises a first solvent and an A-site precursor compound AX and a B-site precursor compound BX₂ dissolved in the first solvent, or comprises a first solvent and an A-site precursor compound AX, a C-site precursor compound CX, and a D-site precursor compound DX₃ dissolved in the first solvent; and the second precursor solution comprises a second solvent and an A-site precursor compound AX, PbX₂, and a third component dissolved in the second solvent, the third component comprises an alkyl group substituted with at least one of a sulfonic acid group, a phosphoric acid group, a carboxylic acid group, a boronic acid group, a cyano group, an amino group, a quaternary ammonium salt, and a mercapto group, the molecular size of the third component is greater than a first threshold, and the first threshold represents the maximum ionic radius of cations of the precursor compounds in the first precursor solution and the second precursor solution;
coating the precursor solution for forming a perovskite layer on the first charge transport layer to form a thin film;
removing the solvent from the thin film to form a perovskite layer, wherein the perovskite layer comprises a perovskite crystal, and the perovskite crystal comprises one or more perovskite grains; the perovskite grain comprises a core portion and a passivation layer located on at least part of a surface of the core portion; the core portion comprises a first perovskite component; the passivation layer comprises a second perovskite component; the first perovskite component comprises one or more of ABX₃ and A₂CDX₆; the second perovskite component comprises one or more of APbX₃; in ABX₃, A₂CDX₆, and APbX₃, A respectively and independently represents a monovalent inorganic cation, organic cation, or organic-inorganic mixed cation, and B represents a divalent inorganic cation, organic cation, or organic-inorganic mixed cation; in ABX₃, A₂CDX₆, and APbX₃, X respectively and independently represents a monovalent inorganic anion, organic anion, or organic-inorganic mixed anion, C represents a monovalent inorganic cation, organic cation, or organic-inorganic mixed cation, and D represents a trivalent inorganic cation, organic cation, or organic-inorganic mixed cation;
forming a second charge transport layer on the perovskite layer; and
forming a second electrode on the second charge transport layer.

17. The method according to claim 16, wherein
the third component comprises one or more of dimethylphosphonic acid, 2,2-dimethylethyleneboronic acid, n-butylamine, glutaronitrile, 4-chlorobenzyl mercaptan, hydrocinnamic acid, and ethylsulfonic acid; and/or,
the molar ratio of the third component to PbX₂ is 0.005:1 to 0.1:1; and/or,
the first solvent comprises dimethylformamide and dimethyl sulfoxide; and/or,
the second solvent comprises dimethylformamide and dimethyl sulfoxide.

18. The method according to any one of claims 16 to 17, wherein the step of removing the solvent from the thin film to form the perovskite layer comprises the following step: transferring the first electrode with the thin film formed to a hot stage to perform annealing treatment to form the perovskite layer.

19. A perovskite layer, wherein
the perovskite layer comprises a middle portion and a passivation portion located on at least part of a surface of the middle portion;
the middle portion comprises a perovskite crystal;
the passivation portion comprises a first passivation portion located on an upper and/or lower surface of the middle portion along a thickness direction, and a second passivation portion located on outer peripheral surfaces of the middle portion;
the first passivation portion and the second passivation portion respectively and independently comprise a passivation material; and the passivation material comprises one or more of a lead-based perovskite material, lead sulfide, silicon carbide, an oxide, a polymer, and an small organic molecule.

20. The perovskite layer according to claim 19, wherein
the ratio of the thickness of the first passivation portion to the thickness of the middle portion is 1:5 to 1:20; and/or,
the ratio of the thickness of the second passivation portion to the thickness of the middle portion is 1:5 to 1:20; and/or,
the thickness of the middle portion is 400-1,000 nm.

21. The perovskite layer according to any one of claims 19 to 20, wherein
the oxides comprise one or more of lead oxide, silicon oxide, aluminum oxide, and tin oxide; and/or,
the polymers comprise one or more of homopolymers and copolymers of at least one monomer from vinyl chloride, thiophene and a derivative thereof, carbazole and a derivative thereof, and styrene sulfonic acid; and/or,
the small organic molecule comprises a compound containing at least one of a halogen atom and a heteroatom, and the heteroatom comprises one or more of N, S, and O.

22. The perovskite layer according to any one of claims 19 to 21, wherein the perovskite crystal comprises the perovskite crystal according to any one of claims 1 to 8.

23. A perovskite cell, comprising:
a first electrode, close to a light incident side;
a second electrode;
a perovskite layer, located between the first electrode and the second electrode;
a first charge transport layer, located between the first electrode and the perovskite layer; and
a second charge transport layer, located between the second electrode and the perovskite layer;
wherein
the perovskite layer comprises the perovskite layer according to any one of claims 19 to 22.

24. The perovskite cell according to claim 23, wherein
the first charge transport layer is a hole transport layer, the second charge transport layer is an electron transport layer, and a LUMO energy level of the first passivation portion is lower than a CBM energy level of the middle portion; or
the first charge transport layer is an electron transport layer, the second charge transport layer is a hole transport layer, and a HOMO energy level of the first passivation portion is greater than a VBM energy level of the middle portion.

25. The perovskite cell according to claim 24, wherein
the first charge transport layer is a hole transport layer, the second charge transport layer is an electron transport layer, the passivation portion comprises a first passivation portion located on a surface of the middle portion away from the first charge transport layer, and a second passivation portion located on outer peripheral surfaces of the middle portion, and a LUMO energy level of the first passivation portion is lower than a CBM energy level of the middle portion; or
the first charge transport layer is an electron transport layer, the second charge transport layer is a hole transport layer, the passivation portion comprises a first passivation portion located on a surface of the middle portion away from the first charge transport layer, and a second passivation portion located on outer peripheral surfaces of the middle portion, and a HOMO energy level of the first passivation portion is greater than a VBM energy level of the middle portion.

26. A method for preparing the perovskite cell according to any one of claims 23 to 25, comprising the following steps:
providing a first electrode;
forming a first charge transport layer on the first electrode;
forming a perovskite layer on the first charge transport layer;
forming a second charge transport layer on the perovskite layer; and
forming a second electrode on the second charge transport layer.

27. The method according to claim 26, wherein a method for forming the perovskite layer on the first charge transport layer comprises a solution method, a hydrothermal method, and a vapor deposition method.

28. The method according to claim 26 or 27, wherein the step of forming the perovskite layer on the first charge transport layer comprises the following steps:
providing a passivation material and a precursor solution for forming the middle portion; and
mixing the passivation material with the precursor solution for forming the middle portion and applying the mixture to the first charge transport layer to form the perovskite layer,
wherein the molar ratio of the passivation material to the precursor for forming the middle portion is 0.01:1 to 0.25:1.

29. The method according to claim 26, wherein the step of forming the perovskite layer on the first charge transport layer comprises the following steps:
providing a precursor solution for forming a middle portion, wherein the precursor solution for forming a middle portion is obtained by mixing a first precursor solution and a second precursor solution; the first precursor solution comprises a first solvent and an A-site precursor compound AX and a B-site precursor compound BX₂ dissolved in the first solvent, or comprises a first solvent and an A-site precursor compound AX, a C-site precursor compound CX, and a D-site precursor compound DX₃ dissolved in the first solvent; and the second precursor solution comprises a second solvent and an A-site precursor compound AX, PbX₂, and a third component dissolved in the second solvent, the third component comprises an alkyl group substituted with at least one of a sulfonic acid group, a phosphoric acid group, a carboxylic acid group, a boronic acid group, a cyano group, an amino group, a quaternary ammonium salt, and a mercapto group, the molecular size of the third component is greater than a first threshold, and the first threshold represents the maximum ionic radius of cations of the precursor compounds in the first precursor solution and the second precursor solution;
coating the precursor solution for forming a middle portion on the first charge transport layer to form a thin film;
removing the solvent from the thin film to form a middle portion; and
applying a passivation material to an upper surface and outer peripheral surfaces of the middle portion to complete preparation of the perovskite layer.

30. The method according to claim 29, wherein before the precursor solution for forming the middle portion is coated on the first charge transport layer to form the thin film, the method further comprises a step of: applying a passivation material to the first charge transport layer.

31. A photovoltaic module, comprising the perovskite cell according to claim 15, or the perovskite cell prepared by the method according to any one of claims 16 to 18, or the perovskite cell according to any one of claims 23 to 25, or the perovskite cell prepared by the method according to any one of claims 26 to 30.

32. An electrical apparatus, comprising one or more of the perovskite cell according to claim 15, the perovskite cell prepared by the method according to any one of claims 16 to 18, the perovskite cell according to any one of claims 23 to 25, the perovskite cell prepared by the method according to any one of claims 26 to 30, and the photovoltaic module according to claim 31, wherein the perovskite cell and the photovoltaic module are used to supply power to the electrical apparatus.
